# EUROPEAN PATENT APPLICATION

(11) **EP 2 800 383 A1**
(43) Date of publication of application: **05.11.2014**
(21) Application number: 12862750.2
(22) Date of filing: 27.12.2012
(51) Int. Cl.: H04N 9/07, H01L 27/14

(54) **COLOR IMAGING ELEMENT**

(30) Priority: 27.12.2011 JP 2011286011
(71) Applicant: Fujifilm Corporation, Minato-ku Tokyo 106-8620 (JP)
(72) Inventor: TANAKA, Seiji, Saitama-shi, Saitama 331-9624 (JP); KAWAI, Tomoyuki, Saitama-shi, Saitama 331-9624 (JP); HAYASHI, Kenkichi, Saitama-shi, Saitama 331-9624 (JP)
(74) Representative: Hoffmann Eitle
(86) International application number: PCT/JP2012/083842
(87) International publication number: WO 2013/100037

(57) **Abstract**

A color filter array of a color imaging element 26 is formed by repeatedly arranging sub array groups 28 in a vertical direction. The sub array groups 28 are formed by alternately arranging A arrays 27a and B arrays 27b each formed by arraying RGB filters 23R, 23G and 23B according to an array pattern corresponding to 4 × 4 pixels. The sub array groups 28 which are mutually adjacent in the vertical direction are arranged by being shifted by one pixel interval in a horizontal direction. G filters 23G are arranged along two diagonal lines of each of the arrays 27a and 27b. The RB filters 23R and 23B are arranged on each filter line in the horizontal and vertical directions of the color filter array in each of the arrays 27a and 27b.

## Description

### {Technical Field}

The preset invention relates to a color imaging element, and, in particular, relates to a color imaging element which can reduce generation of color moire and convert a resolution into a higher resolution.

### {Background Art}

In a single-plate color imaging element, a color filter of a single color is provided on each pixel, and therefore each pixel has only color information of a single color. Hence, an output image of a single-plate color imaging element becomes a RAW image (mosaic image), and therefore multichannel images are obtained by processing (demosaicing processing) of interpolating pixels of deficient colors from surrounding pixels. What matters in this case is reproduction characteristics of a high frequency image signal. Since the color imaging element is likely to cause aliasing in a captured image compared to a monochrome imaging element, an important task is to convert a resolution into a high resolution by expanding a reproduction band while suppressing generation of color moire (false color).

The demosaicing processing refers to processing of calculating all pieces of color information per pixel from a mosaic image corresponding to a color filter array of a single-plate color imaging element, and is also referred to as concurrent processing. For example, when an imaging element includes color filters of three colors RGB, the demosaicing processing is the process for calculating all pieces of color information of RGB per pixel from a mosaic image configured by RGB.

In a primary color Bayer array, which is the most widely used color array of color filters in the single-plate color imaging elements, green (G) pixels are arranged in a checkered pattern and red (R) and blue (B) are arranged in a line sequence, and therefore there is a problem with reproduction precision when G signals generate high frequency signals in diagonal directions, and when R and B signals generate high frequency signals in horizontal and vertical directions.

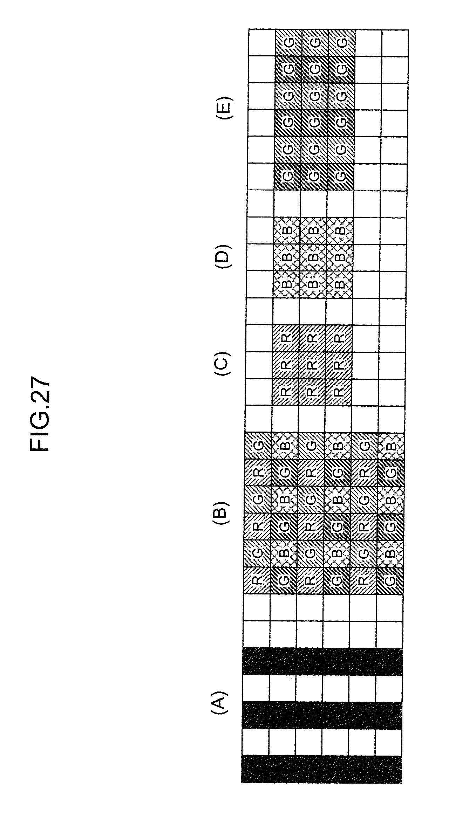

When a monochrome vertical stripe pattern (high frequency image) as indicated by the A portion in Figure 27 is incident on a color imaging element including color filters of a Bayer array indicated by the B portion in Figure 27, a color image of a mosaic pattern is provided in which R is light and flat, B is dark and flat and G is a light and dark as indicated by the C portion to E portion in Figure 27 upon comparison with each color by sorting the pattern into the Bayer color array. Originally, a density difference (level difference) is not produced among RGB since the image is monochrome, but depending on a color array and an input frequency, a color is applied to the image.

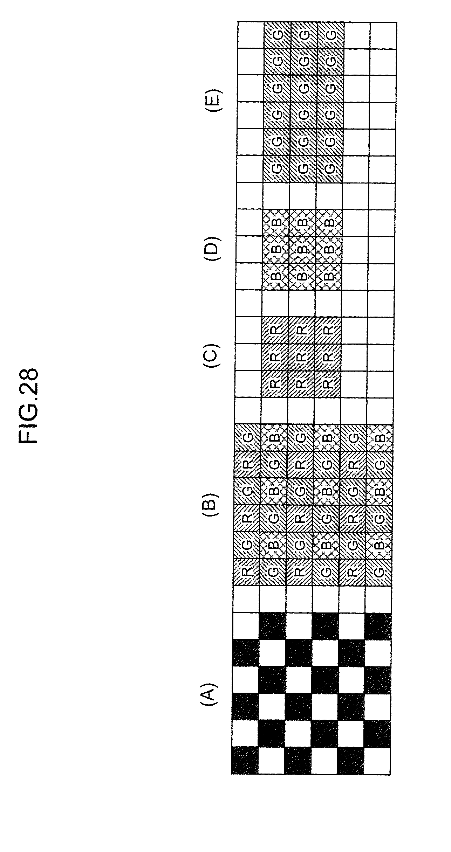

Similarly, when a diagonally monochrome high frequency image as indicated by the A portion in Figure 28 is incident on an imaging element including color filters of a Bayer array indicated by the B portion in Figure 28, a color image is provided in which R and B are light and flat and G is dark and flat as indicated by the C to E portions in Figure 28 upon comparison with each color by sorting the pattern into the Bayer color array. If a value of black is 0 and a value of white is 255, the diagonally monochrome high frequency image becomes green-colored since only G takes 255. Thus, the Bayer array cannot correctly reproduce a diagonal high frequency image.

Generally, in an imaging apparatus which uses single-plate color imaging elements, optical low pass filters made of a birefringent material such as crystal are arranged in front of the color imaging elements to optically suppress a high frequency wave. This method can reduce a tinge due to aliasing of a high frequency signal, but has a problem that the resolution lowers due to a negative effect of this method.

To solve such a problem, color imaging elements is proposed which adopt a three color random array which satisfies array limitation conditions that arbitrary pixels of interest are adjacent to three colors including colors of the pixels of interest in one of four sides of the pixels of interest (PTL 1).

Further, an image sensor is proposed which has a plurality of filters of different spectral sensitivities having a color filter array in which first filters and second filters are alternately arranged in a first predetermined cycle in one of diagonal directions of a pixel grid of the image sensor, while they are alternately arranged in a second predetermined cycle in the other one of the diagonal directions (PTL 2).

Furthermore, in a color solid state imaging element of three primary colors of RGB, a color array is proposed which makes each appearance probability of RGB equal, and allows arbitrary lines (horizontal, vertical and diagonal lines) on an imaging plane to transit all colors by arranging sets of three pixels of horizontally-arranged R, G and B in a zig-zag pattern in the vertical direction (PTL 3).

Still further, a color imaging element is proposed in which R and B of the three primary colors of RGB are arranged every three pixels in the horizontal and the vertical directions, and G is arranged between these R and B (PTL 4).

### {Citation List}

### {Patent Literature}

{PTL 1}: Japanese Patent Application Laid-Open No.2000-308080
{PTL 2}: Japanese Patent Application Laid-Open No.2005-136766
{PTL 3}: Japanese Patent Application Laid-Open No.11-285012
{PTL 4} : Japanese Patent Application Laid-Open No.8-23543

### {Summary of Invention}

### {Technical Problem}

The color imaging element described in PTL 1 needs to optimize each random pattern when demosaicing processing is performed at a subsequent stage since a filter array is random, and has a problem that the demosaicing processing becomes complicated. Further, the random array is effective for color moire of a low frequency, but is not effective for a false color of a high frequency portion.

Furthermore, the image sensor described in PTL 2 has a problem that pixel reproduction precision is poor in a limited resolution region (in the diagonal directions in particular), because G pixels (brightness pixels) are arranged in a checkered pattern.

The color solid state imaging element described in PTL 3 provides an advantage that it is possible to suppress generation of a false color since there are filters of all colors on arbitrary lines, but has a problem that high frequency reproducibility lowers compared to the Bayer array because the ratios of the numbers of pixels of RGB are equal. In case of the Bayer array, the ratio of the number of pixels of G, which contributes the most to acquisition of a brightness signal, is twice as much as the numbers of pixels of R and B.

On the other hand, in the color imaging element described in PTL 4, the ratio of the number of pixels of G with respect to the numbers of pixels of R and B is higher than the ratio of that in the Bayer array, but is not effective for a false color of a high frequency portion in a horizontal or vertical direction because there are lines of only G pixels in the horizontal or vertical direction.

The present invention has been made in light of such a situation, and an object of the present invention is to provide a color imaging element which can suppress generation of a false color and convert a resolution into a higher resolution, and simplify processing at a subsequent stage compared to a conventional random array.

### {Solution to Problem}

To achieve the above-mentioned object, the invention according to one aspect of the present invention is a single-plate color imaging element which is formed by disposing color filters on a plurality of pixels formed with photoelectric conversion elements arrayed in a horizontal direction and a vertical direction, in an array of the color filters, sub arrays formed by arraying the color filters according to an array pattern corresponding to N × N (N is an even number) pixels are included, sub array groups formed by arranging the sub arrays in one direction of the horizontal direction and the vertical direction are repeatedly arranged in another direction of the horizontal direction and the vertical direction, and the sub array groups which are mutually adjacent in the other direction are arranged by being shifted by M (M is less than N) pixel intervals in the one direction, the color filters include first filters corresponding to a first color with one or more colors and second filters corresponding to a second color with two or more colors whose contribution rates for acquiring a brightness signal are lower than a contribution rate of the first color, and further a ratio of a number of pixels of the first color corresponding to the first filters is greater than a ratio of a number of pixels of each color of the second color corresponding to the second filters, the first filters are arranged along at least a diagonal line of the sub arrays, one or more of the second filters corresponding to each color of the second color are arranged on each filter line in the horizontal and vertical directions of the array of the color filters in a basic array pattern, the basic array pattern being repeatedly arranged in the horizontal direction and the vertical direction in the array of the color filters, and corresponding to arbitrary 2N × 2N pixels included in the array of the color filters, and the M is set to such a value that one or more of the first filters are arranged on each filter line in horizontal, vertical, diagonal upper right and diagonal lower right directions of the array of the color filters.

According to the invention pertaining to one aspect of the present invention, sub array groups formed by arranging the sub arrays in one direction of the horizontal and vertical directions are repeatedly arranged in the other direction of the horizontal and vertical directions, the first filters whose contribution rate for acquiring brightness signal is high are arranged at least on diagonal lines of each sub array, and the mutually adjacent sub array groups are arranged by being shifted such that the one or more of the first filters are arranged on each filter line in the horizontal, vertical, diagonal upper right and diagonal lower right directions of the color filter array, so that it is possible to increase reproduction precision of demosaicing processing in a high frequency region.

Further, in the color filter array, specific basic array patterns are repeatedly arranged in the horizontal and the vertical directions, so that it is possible to perform processing according to a repetition pattern when performing the demosaicing processing at a subsequent stage, and simplify the processing at the subsequent stage compared to the conventional random array.

Furthermore, one or more of the second filters corresponding to each color of the second color with two or more colors other than the first color are arranged on each filter line in horizontal and vertical directions of the color filter array in the basic array pattern, so that it is possible to suppress generation of color moire (false color) and convert a resolution into a high resolution.

The ratios of the number of pixels of the first color corresponding to the first filters and the number of pixels of each color of the second color with two or more colors corresponding to the second filters are different, and in particular the ratio of the number of pixels of the first color whose contribution rate for acquiring a brightness signal is high is greater than a ratio of the number of pixels of each color of the second color corresponding to the second filters, so that it is possible to suppress aliasing and high frequency reproducibility is also good.

Further, the basic array pattern is formed by an array pattern corresponding to 2N × 2N pixels, so that, when, for example, a color imaging element is a CMOS (Complementary Metal Oxide Semiconductor) imaging element, it is possible to share one amplifier circuit among an even number of (for example, four) pixels.

In the color imaging element according to another aspect of the present invention, preferably, the basic array pattern includes one or more of the sub arrays included in each of the mutually adjacent sub array groups. It is possible to perform processing according to a repetition pattern when performing demosaicing processing at a subsequent stage, and simplify the processing at a subsequent stage compared to the conventional random array.

In the color imaging element according to another aspect of the present invention, preferably, N is an even number of 4 or more, and the first filter is arranged along at least two diagonal lines of the sub arrays. Consequently, at least one or more of the first filters are arranged on each filter line in the horizontal and vertical directions of the color filter array.

In the color imaging element according to still another aspect of the present invention, preferably, one or more of the second filters of each color of the second color are arranged on each filter line in the horizontal and vertical directions of the array of the color filters in the sub arrays. Consequently, one or more of the second filters corresponding to the second color with two or more colors are arranged on each filter line in the horizontal and vertical directions of the array of the color filters in the basic array pattern, too.

In the color imaging element according to still another embodiment of the present invention, preferably, the array of the color filters includes a square array corresponding to 2 × 2 pixels formed with the first filters. Consequently, it is possible to determine a high correlation direction among the horizontal, vertical, diagonal upper right and diagonal lower right directions using pixel values of 2 × 2 pixels.

In the color imaging element according to still another aspect of the present invention, preferably, when the N is 2, the first filter is arranged along one diagonal line of the sub arrays. Consequently, one or more of the first filters are arranged on each filter line in the horizontal and vertical directions of the color filter array.

In the color imaging element according to still another aspect of the present invention, preferably, an even-numbered sub array group arranged in the other direction is arranged by being shifted by the M pixel intervals in the other direction from an odd-numbered sub array group arranged in the other direction. Consequently, one or more of the first filters are arranged on each filter line in the horizontal, vertical, diagonal upper right and diagonal lower right directions of the color filter array.

In the color imaging element according to still another aspect of the present invention, preferably, N is 10 or less. When N exceeds 10 (N > 10), while signal processing such as demosaicing processing becomes complicated, a special effect cannot be provided by increasing a size of the basic array pattern.

In the color imaging element according to still another embodiment of the present invention, preferably, the first color is green (G), and the second color is red (R) and blue (B). Note that an imaging apparatus which has the above-mentioned color imaging element is also incorporated in the present invention.

### {Advantageous Effects of Invention}

According to the present invention, one or more of the first filters corresponding to the first color whose contribution rate for acquiring a brightness signal is high are arranged on each filter line in the horizontal, vertical, diagonal upper right and diagonal lower right directions of the color filter array, and the ratio of the number of pixels of the first color corresponding to the first filters is greater than the ratio of the number of pixels of the second filters corresponding to each color of the second color with two or more colors other than the first color, so that it is possible to increase reproduction precision of demosaicing processing in a high frequency region, and suppress aliasing.

Further, one or more of the second filters corresponding to each color of the second color with two or more colors other than the first color are arranged on each filter line in the horizontal and vertical directions of the color filter array in the basic array pattern, so that it is possible to suppress generation of color moire (false color) and convert a resolution into a high resolution.

Further, in the array of the color filter according to the present invention, the specific basic array patterns are repeated in the horizontal and the vertical directions, so that it is possible to perform processing according to a repetition pattern when performing demosaicing processing at a subsequent stage, and simplify the processing at a subsequent stage compared to the conventional random array.

### {Brief Description of Drawings}

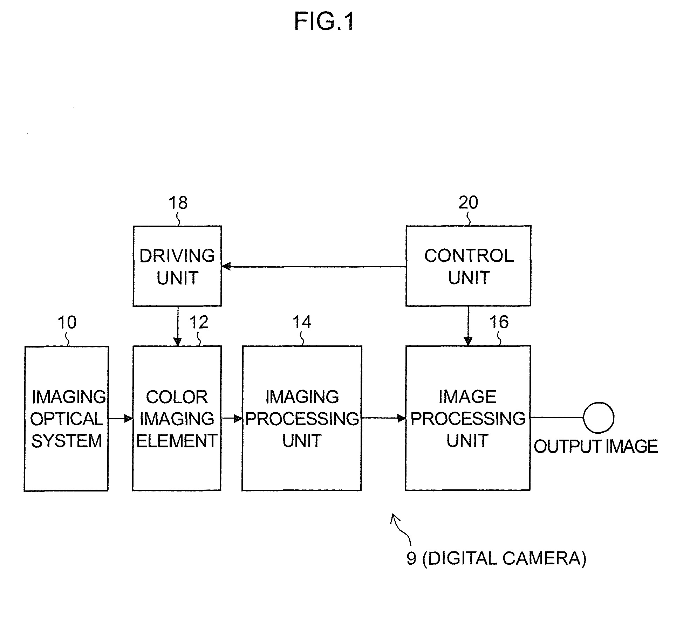

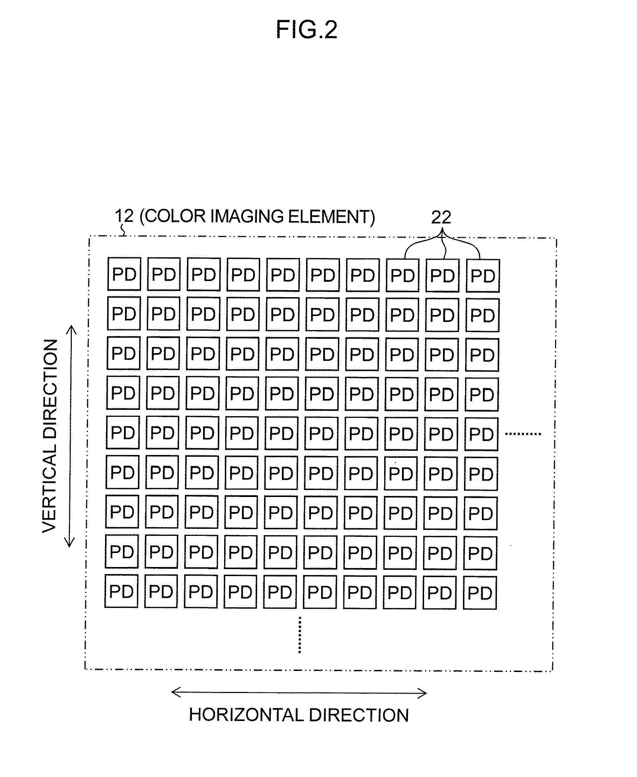

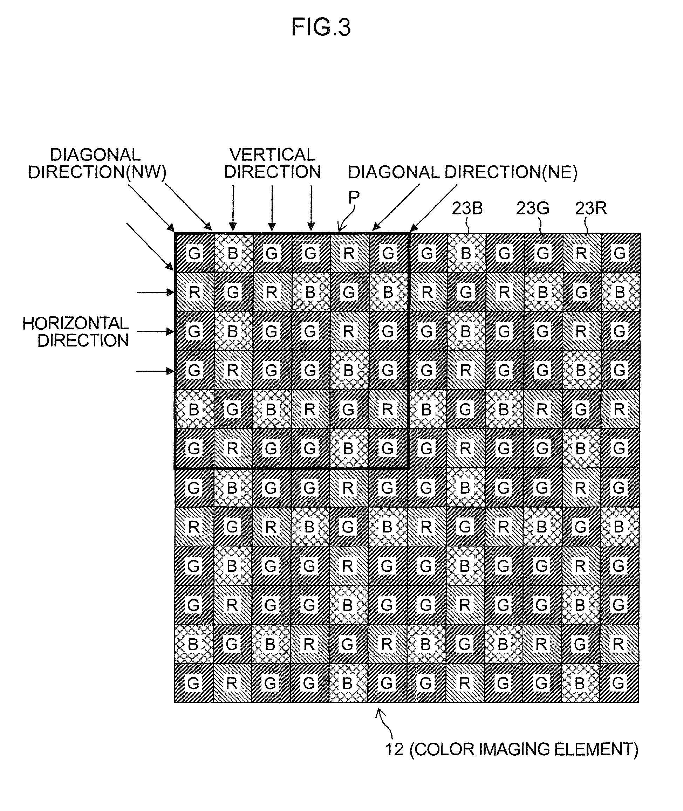

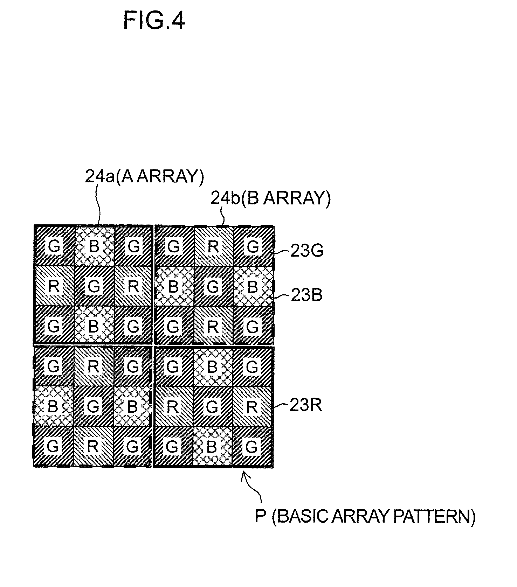

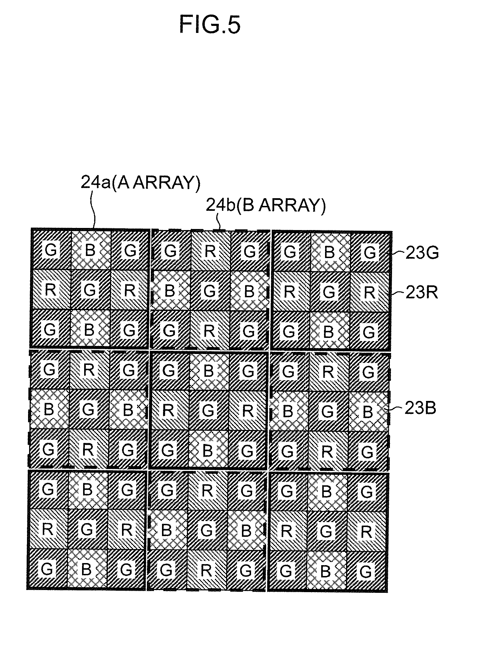

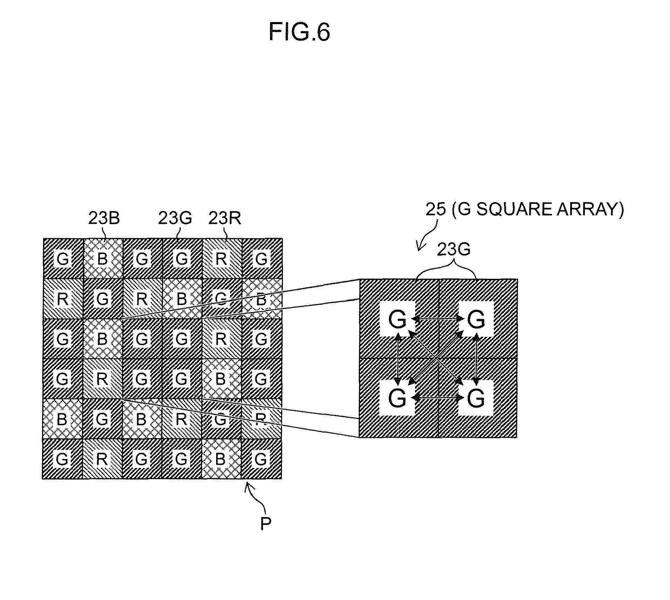

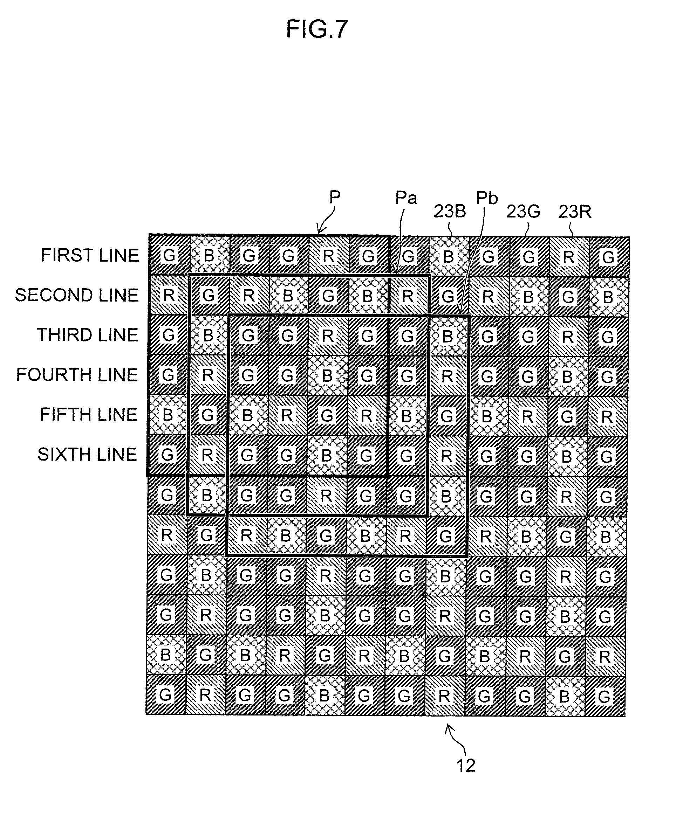

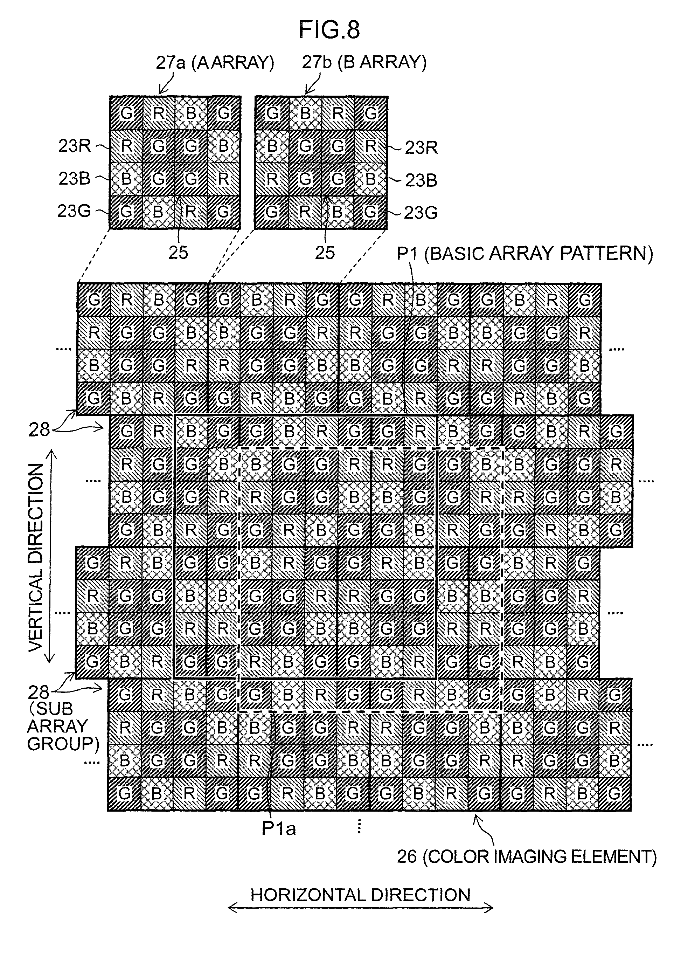

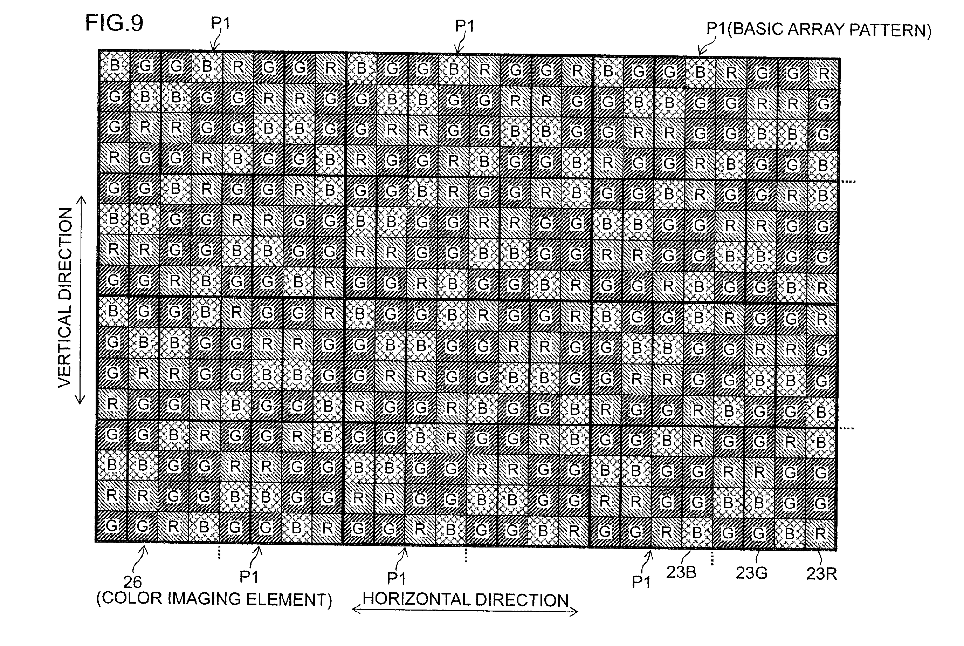

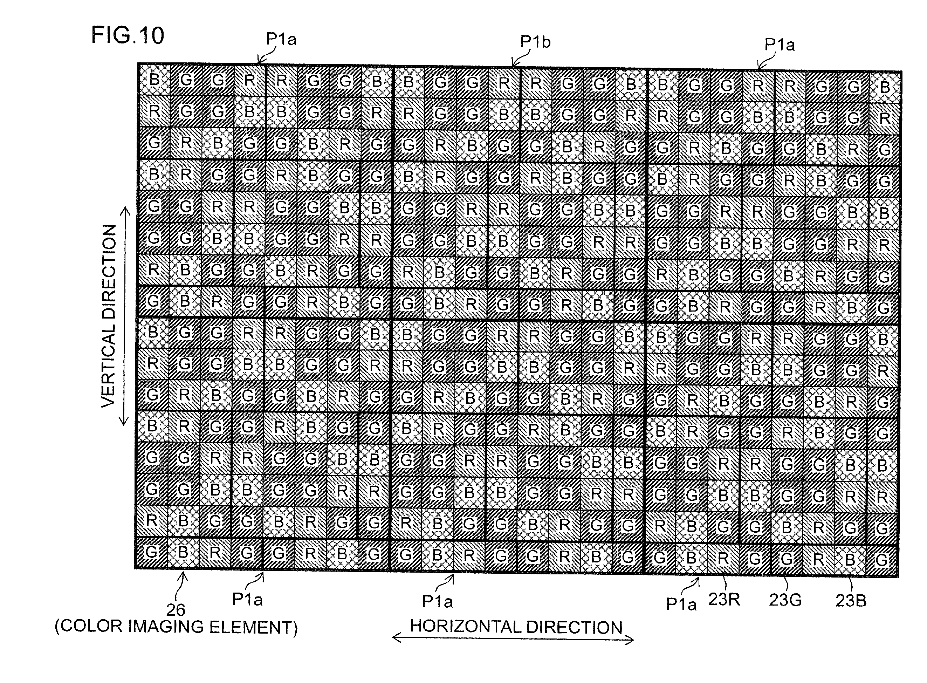

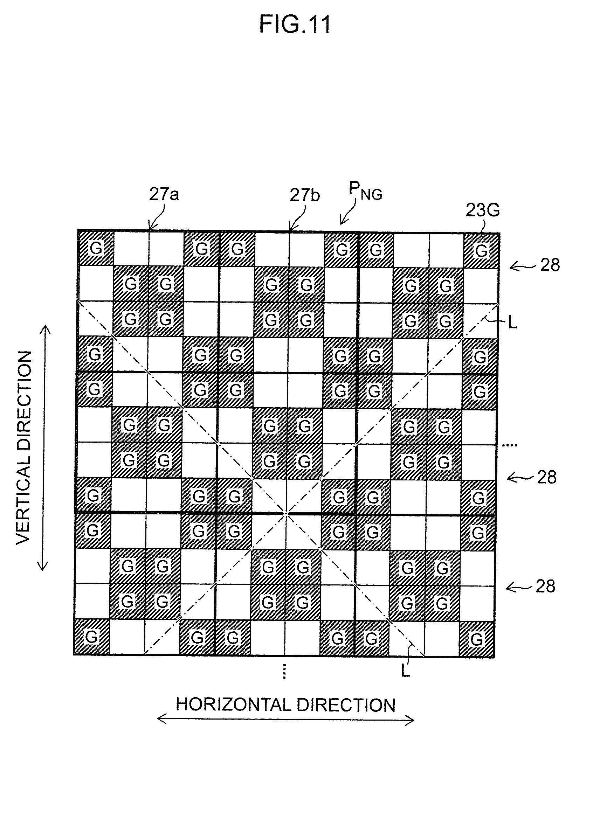

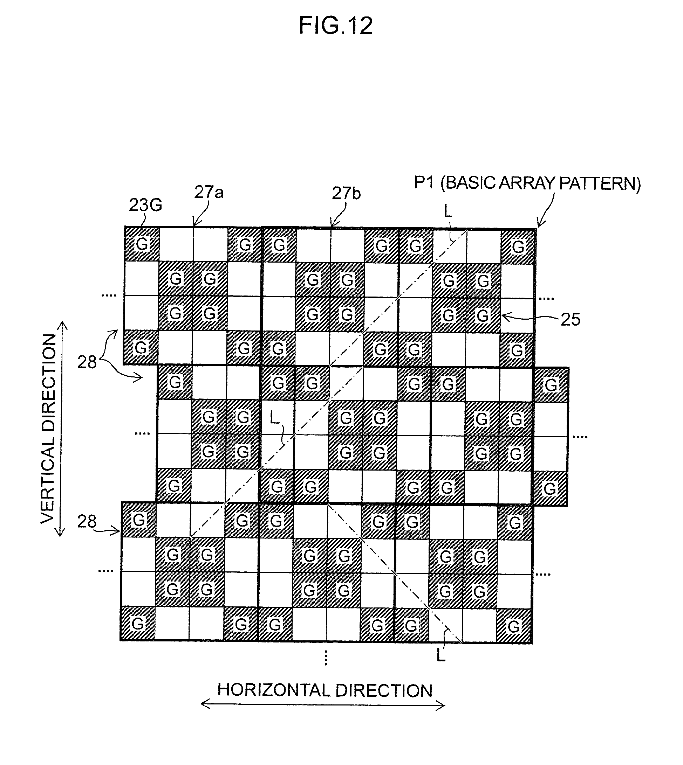

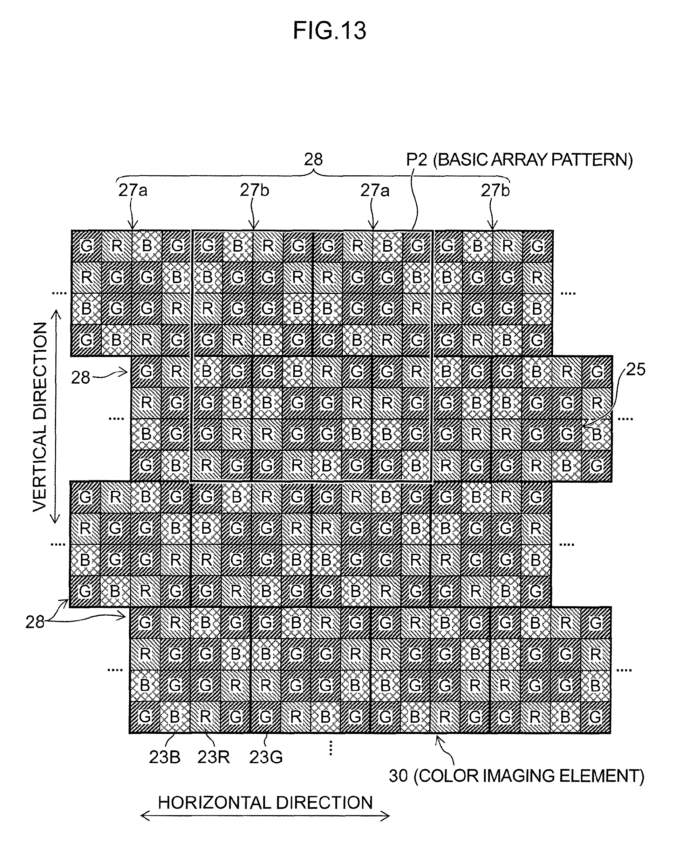

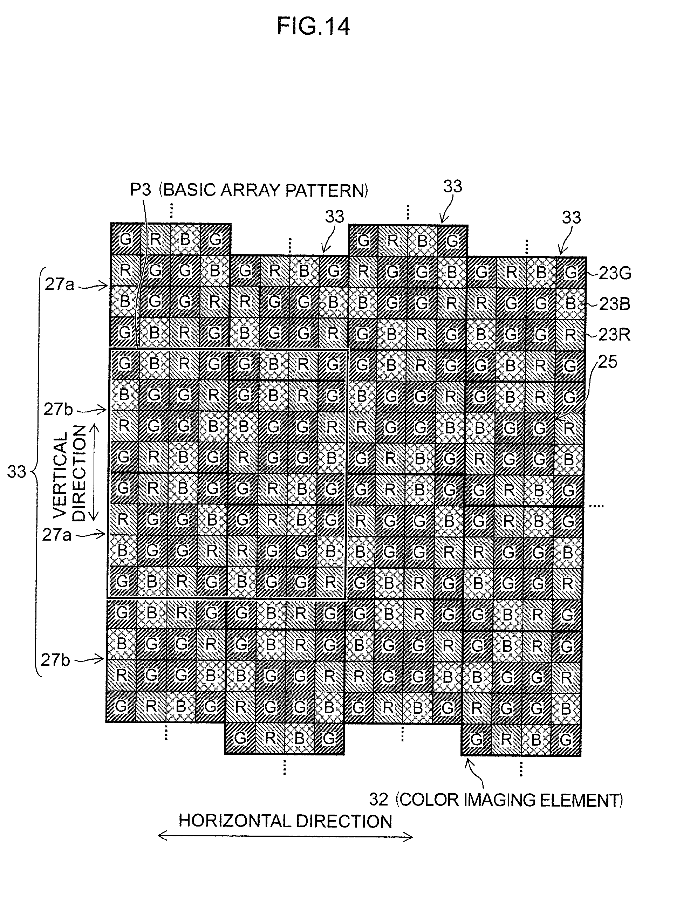

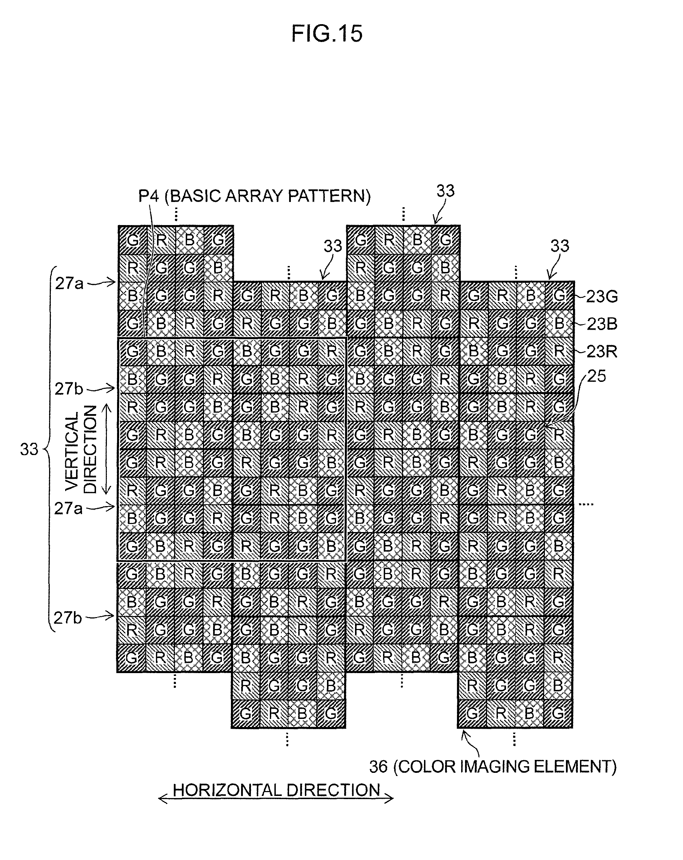

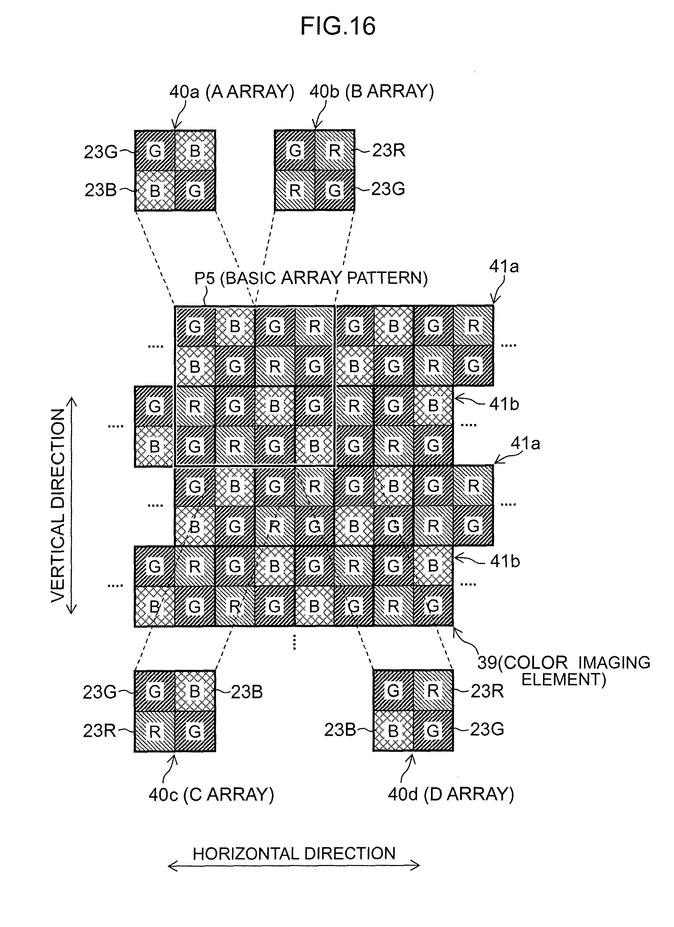

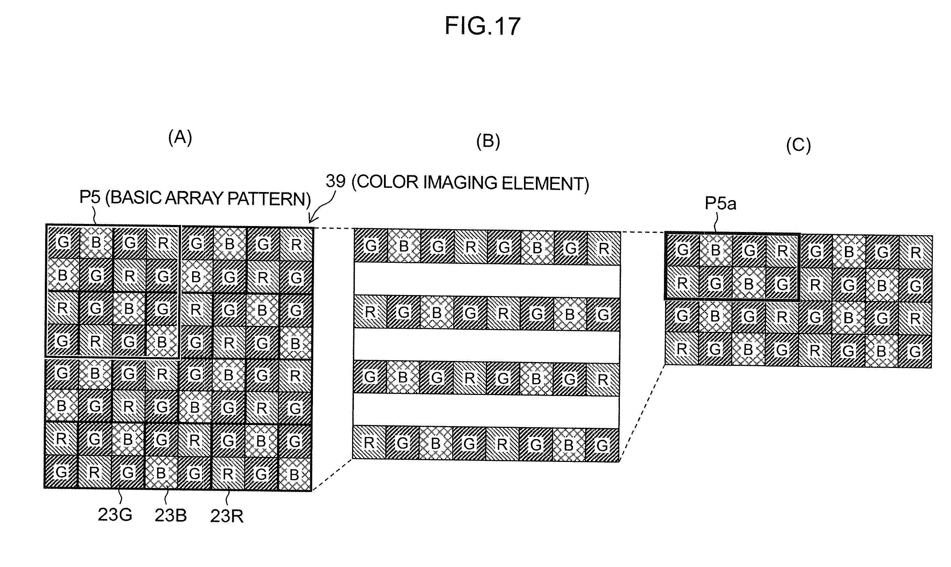

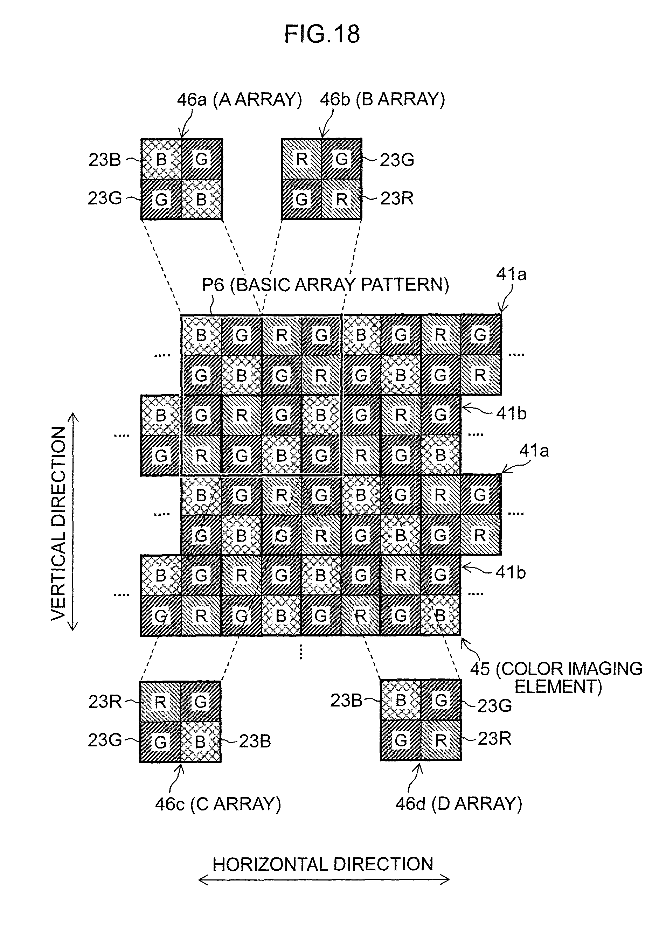

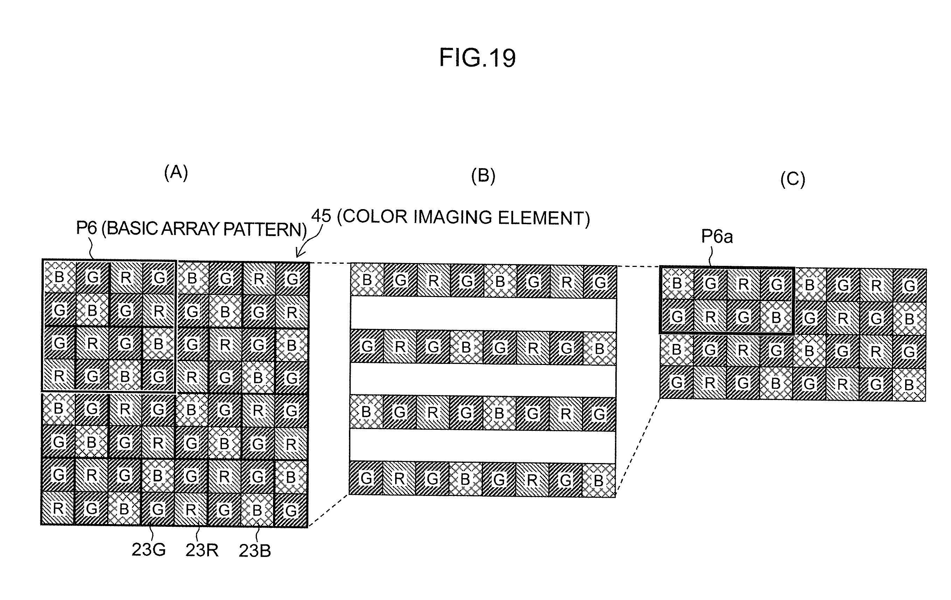

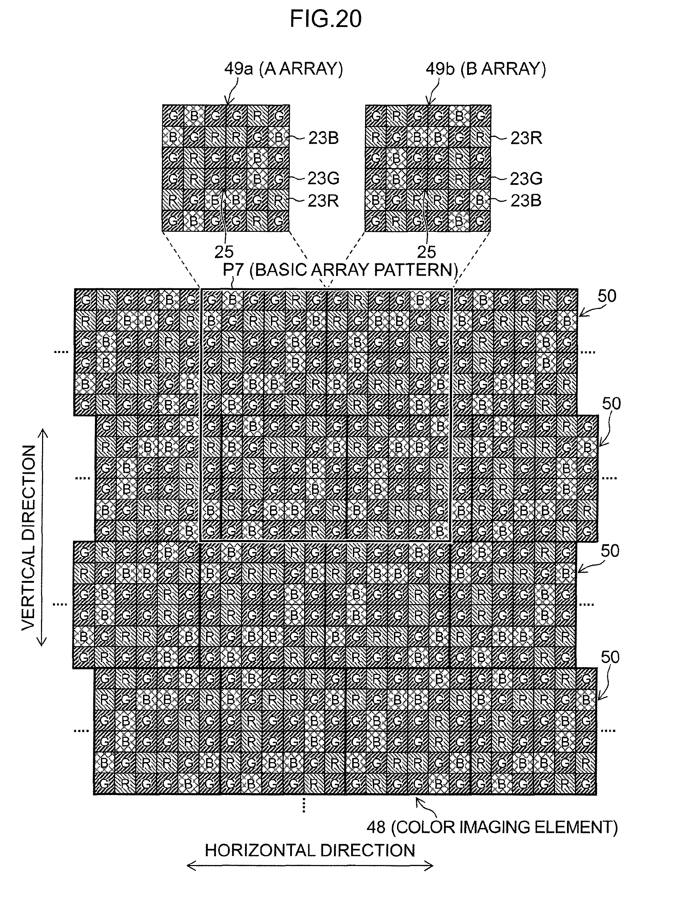

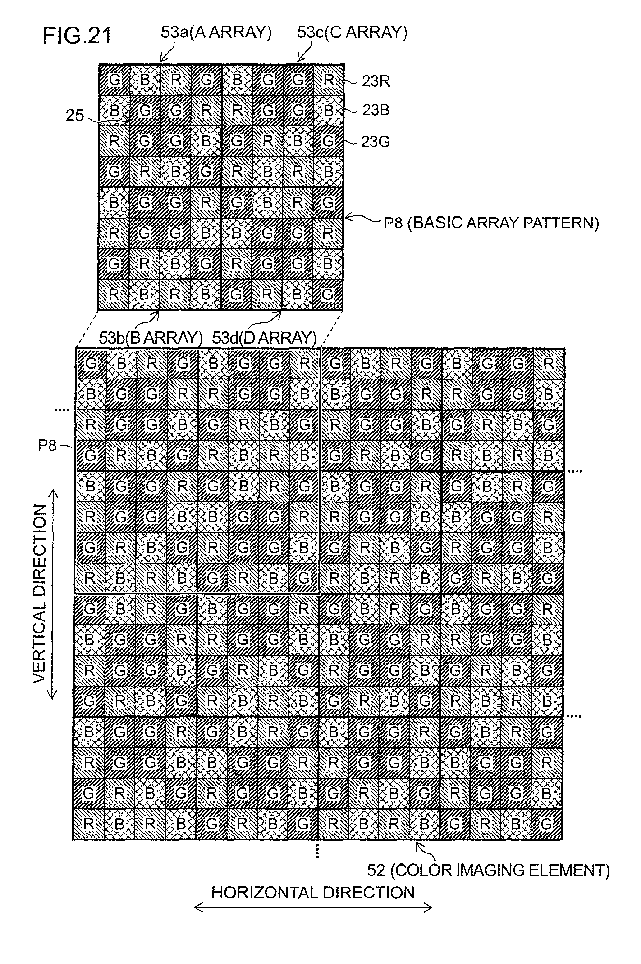

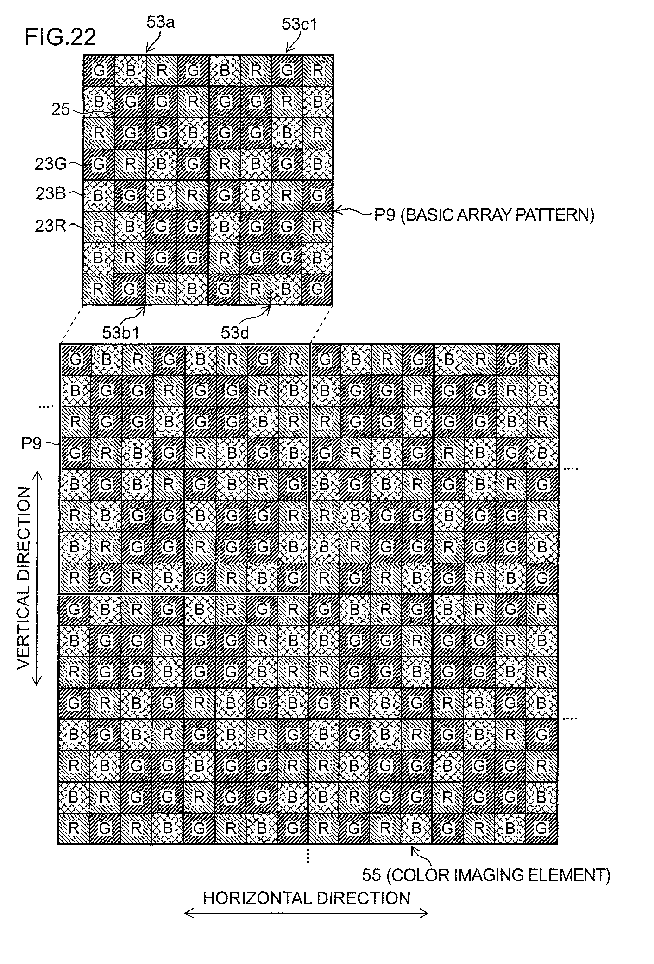

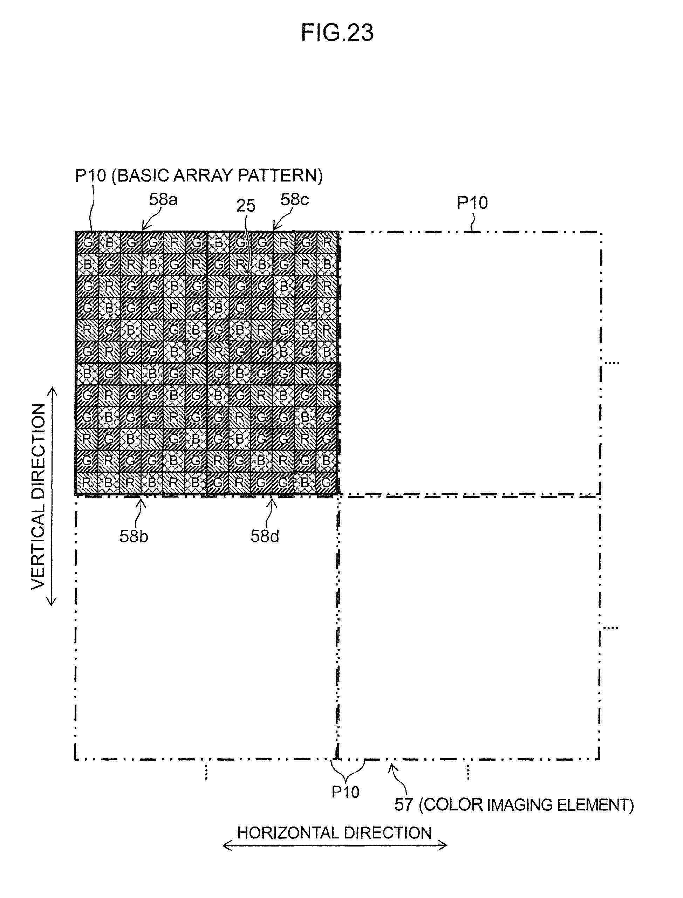

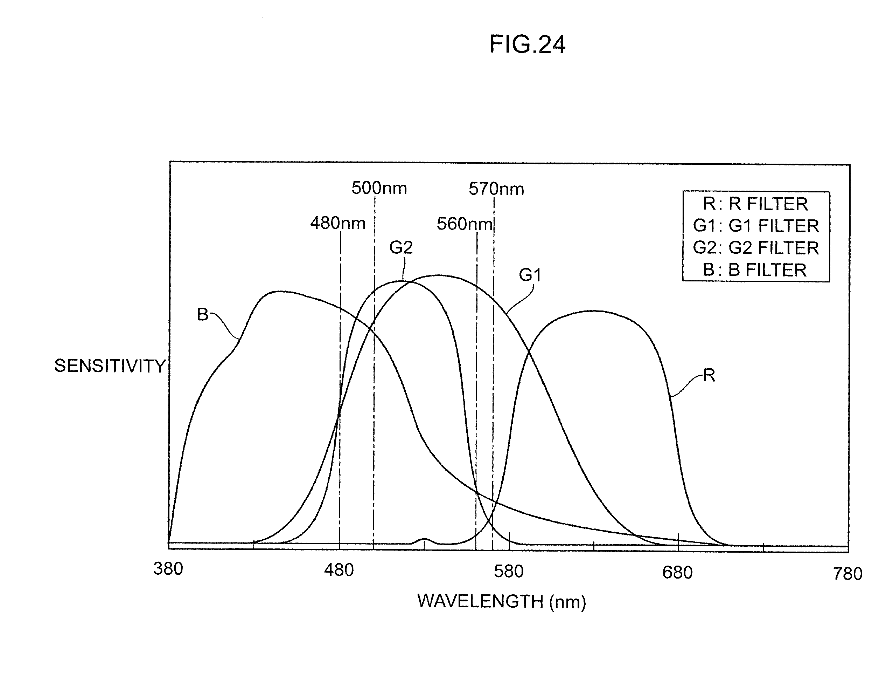

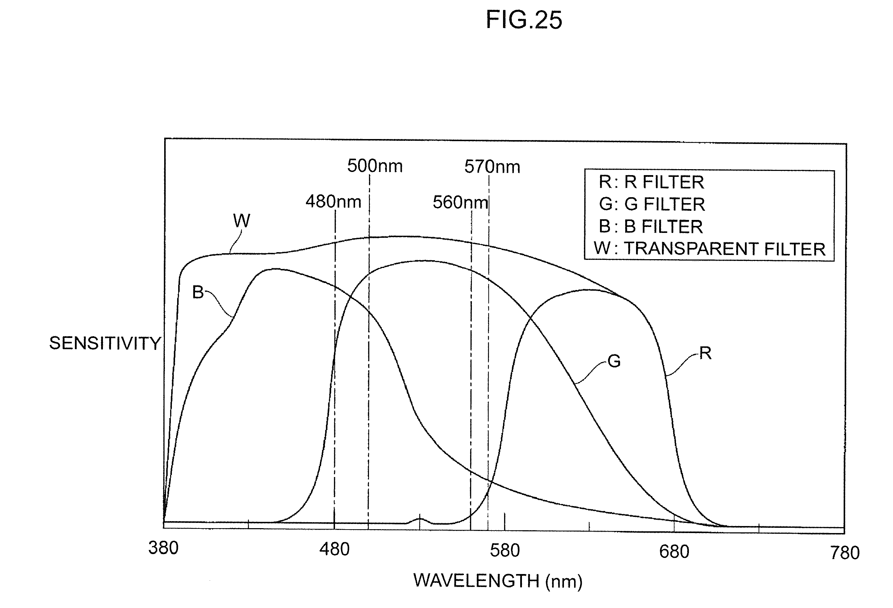

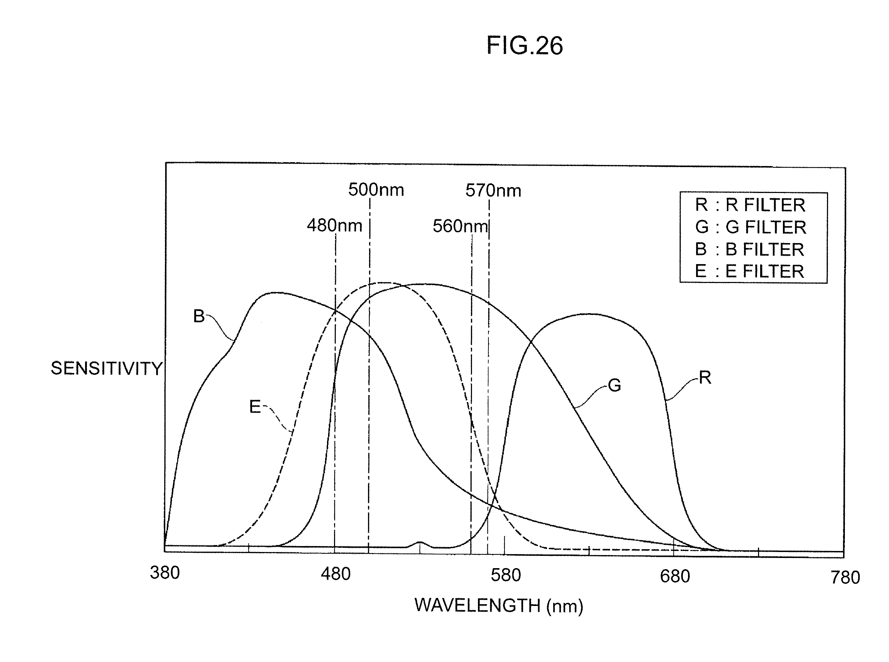

{Figure 1} Figure 1 is a view illustrating a digital camera which has a single-plate color imaging element according to the present invention.
{Figure 2} Figure 2 is a view illustrating pixels of the single-plate color imaging element according to the present invention.
{Figure 3} Figure 3 is a view illustrating a single-plate color imaging element according to a first embodiment of the present invention.
{Figure 4} Figure 4 is a view illustrating a basic array pattern included in a color filter array of the color imaging element according to the first embodiment.
{Figure 5} Figure 5 is a view illustrating an arrangement in which basic array patterns of 6 × 6 pixels included in the color filter array of the color imaging element according to the first embodiment are divided into A arrays and B arrays of 3 × 3 pixels, and arranged.
{Figure 6} Figure 6 is a view used to explain a method of determining a correlation direction from pixel values of G pixels of 2 × 2 pixels included in the color filter array of the color imaging element according to the first embodiment.
{Figure 7} Figure 7 is a view used to explain a concept of basic array patterns included in the color filter array of the color imaging element.
{Figure 8} Figure 8 is a view illustrating a single-plate color imaging element according to a second embodiment of the present invention.
{Figure 9} Figure 9 is a view for explaining that the color filter array illustrated in Figure 8 is obtained by repeatedly arranging basic array patterns in horizontal and vertical directions.
{Figure 10} Figure 10 is a view for explaining that the color filter array illustrated in Figure 8 is obtained even when basic array patterns different from the basic array patterns illustrated in Figure 9 are repeatedly arrayed in the horizontal and vertical directions.
{Figure 11} Figure 11 is a view illustrating a color filter array as a comparative example where mutually adjacent sub array groups are arranged without being shifted from each other.
{Figure 12} Figure 12 is a view used to explain that lines on which G filters are not arranged are not produced in a diagonal upper right (NE) and diagonal lower right (NW) directions in a color filter array of the color imaging element according to the second embodiment.
{Figure 13} Figure 13 is a view illustrating a single-plate color imaging element according to a third embodiment of the present invention.
{Figure 14} Figure 14 is a view illustrating a single-plate color imaging element according to a fourth embodiment of the present invention.
{Figure 15} Figure 15 is a view illustrating a single-plate color imaging element according to a fifth embodiment of the present invention.
{Figure 16} Figure 16 is a view illustrating a single-plate color imaging element according to a sixth embodiment of the present invention.
{Figure 17} Figure 17 is an explanatory view for explaining a color filter array upon thinning, reading and driving of the color imaging element according to the sixth embodiment.
{Figure 18} Figure 18 is a view illustrating a single-plate color imaging element according to a seventh embodiment of the present invention.
{Figure 19} Figure 19 is an explanatory view for explaining a color filter array upon thinning, reading and driving of the color imaging element according to the seventh embodiment.
{Figure 20} Figure 20 is a view illustrating a single-plate color imaging element according to an eighth embodiment of the present invention.
{Figure 21} Figure 21 is a view illustrating a single-plate color imaging element according to a ninth embodiment of the present invention.
{Figure 22} Figure 22 is a view illustrating a single-plate color imaging element according to a tenth embodiment of the present invention.
{Figure 23} Figure 23 is a view illustrating a single-plate color imaging element according to an eleventh embodiment of the present invention.
{Figure 24} Figure 24 is a graph illustrating spectral sensitivity characteristics of light receiving elements on which an R filter (red filter), a G1 filter (first green filter), a G2 filter (second green filter) and a B filter (blue filter) are arranged.
{Figure 25} Figure 25 is a graph illustrating spectral sensitivity characteristics of light receiving elements on which the R filter, the G filter, the B filter and a W filter (transparent filter) are arranged.
{Figure 26} Figure 26 is a graph illustrating spectral sensitivity characteristics of light receiving elements on which the R filter, the G filter, the B filter and an emerald filter (E filter) are arranged.
{Figure 27} Figure 27 is a view used to explain a problem of a color imaging element which has color filters of a conventional Bayer array.
{Figure 28} Figure 28 is another view used to explain a problem of the color imaging element which has the color filters of the conventional Bayer array.

### {Description of Embodiments}

Preferred embodiments of the present invention are described below in detail with reference to the accompanying drawings.

### [Entire Configuration of Color Imaging Apparatus]

Figure 1 is a block diagram of a digital camera 9 which has color imaging elements according to the present invention. The digital camera 9 roughly has an imaging optical system 10, a color imaging element 12, an imaging processing unit 14, an image processing unit 16, a driving unit 18 and a control unit 20 or the like.

The imaging optical system 10 captures an image of a subject, and an optical image which shows a subject image is formed on a light receiving plane of the color imaging element 12 (a color imaging element according to the first embodiment).

The color imaging element 12 is a so-called single-plate color imaging element which has on an imaging plane a plurality of pixels formed with photoelectric conversion elements arrayed (two-dimensionally arrayed) in a horizontal direction and a vertical direction in Figure 2, and color filters of a specific color filter array arranged above the light receiving plane of each pixel. In this regard, "above" refers to a direction from which subject light is incident on the imaging plane of the color imaging element 12.

A subject image formed on the color imaging element 12 is converted into a signal charge corresponding to the amount of incident light by the photoelectric conversion element of each pixel. Signal charges accumulated in each photoelectric conversion element are sequentially read from the color imaging element 12 as voltage signals (image signals) corresponding to the signal charge based on a driving pulse given from the driving unit 18 according to a command of the control unit 20. The image signals read from the color imaging element 12 are R, G and B signals indicating red (R), green (G) and blue (B) mosaic images corresponding to the color filter array of the color imaging element 12.

The image signals read from the color imaging element 12 are inputted to the imaging processing unit 14. The imaging processing unit 14 has a correlated double sampling circuit (CDS) which cancels reset noise included in the image signals, an AGC circuit which amplifies an image signal and controls the image signal at a certain level of magnitude, and an A/D converter. This imaging processing unit 14 performs correlated double sampling processing on the inputted image signal and amplifies the image signal, and then outputs RAW data obtained by converting the image signal into a digital image signal, to the image processing unit 16.

The image processing unit 16 has a white balance correction circuit, a gamma correction circuit, a demosaicing processing circuit (a processing circuit which calculates (converts in a concurrent way) all pieces of color information of RGB per pixel from RGB mosaic images related to the color filter array of the single-plate color imaging element 12), a brightness/color difference signal generation circuit, an outline correction circuit, a color correction circuit, or the like. The image processing unit 16 applies required signal processing to the RAW data of the mosaic images inputted from the imaging processing unit 14 according to the command from the control unit 20, and generates image data (YUV data) which includes brightness data (Y data) and color difference data (Cr and Cb data).

The image data generated by the image processing unit 16 is subjected to compression processing by a compression/extension processing circuit based on the JPEG standards when the image data is a still image, or based on the MPEG2 standards when the image data is a moving image, and then the image data is recorded in a recording medium (e.g. a memory card) not illustrated or is outputted to be displayed on display means (not illustrated) such as a liquid crystal monitor.

### [Color Imaging Element according to First Embodiment]

Figures 2 and 3 are views illustrating a single-plate color imaging element according to a first embodiment of the present invention. Figure 2 illustrates a pixel array of pixels provided to the color imaging element 12 and Figure 3 illustrates a color filter array of color filters.

As illustrated in Figure 2, the color imaging element 12 has a plurality of pixels formed with photoelectric conversion elements 22 arrayed (two-dimensionally arrayed) in the horizontal direction and the vertical direction, and color filters of a color filter array, as illustrated in Figure 3, arranged above the light receiving plane of each pixel. Any one of color filters 23R, 23G and 23B of three primary colors of RGB (referred to as an R filter, a G filter and a B filter) is arranged on each pixel. Hereinafter, a pixel on which the R filter 23R is arranged is referred to as an "R pixel", a pixel on which the G filter 23G is arranged is referred to as a "G pixel", and a pixel on which the B filter 23B is arranged is referred to as a "B pixel".

Note that the color imaging element 12 is not limited to a CCD (Charge Coupled Device) color imaging element, and may be other types of imaging elements such as a CMOS (Complementary Metal Oxide Semiconductor) imaging element.

### <Features of Color Filter Array>

The color filter array of the color imaging element 12 according to the first embodiment includes the following features (1), (2), (3), (4), (5) and (6).

### [Feature (1)]

The color filter array illustrated in Figure 3 includes a basic array pattern P (a pattern indicated by a bold frame in the figure) formed with a square array pattern corresponding to 6 × 6 pixels, and this basic array pattern P is repeatedly arranged in the horizontal direction and the vertical direction. That is, in this color filter array, the R filters 23R, the G filters 23G and the B filters 23B of each color of R, G and B are cyclically arrayed.

As described above, the R filters 23R, the G filters 23G and the B filters 23B are cyclically arrayed, so that it is possible to perform processing according to a repetition pattern when performing demosaicing processing and the like on R, G and B signals read from the color imaging element 12.

Further, when thinning processing is performed in units of the basic array patterns P to reduce an image, the color filter array after the thinning processing is the same as the color filter array before the thinning processing and a common processing circuit can be used.

### [Feature (2)]

In the color filter array illustrated in Figure 3, one or more of the G filters 23G corresponding to a color (the color of G in the present embodiment) which contributes the most to acquisition of a brightness signal are arranged on each filter line in the horizontal, vertical and diagonal (NE, NW) directions of the color filter array. In this regard, NE designates a diagonal upper right direction, and NW designates a diagonal lower right direction. The diagonal upper right and lower right directions are each of the directions of 45° with respect to the horizontal direction in the case of, for example, a square array of pixels, and are the directions of diagonal lines of a rectangular shape in the case of a rectangular array of pixels, and the angle of its direction may vary according to lengths of long sides and short sides.

One or more of the G filters 23G corresponding to brightness pixels are arranged on each filter line in the horizontal, vertical and diagonal (NE, NW) directions of the color filter array, so that it is possible to increase reproduction precision of the demosaicing processing in a high frequency region irrespectively of a direction in which a high frequency wave is provided.

### [Feature (3)]

According to the basic array pattern P of the color filter array illustrated in Figure 3, the numbers of pixels of R pixels, G pixels and B pixels corresponding to the RGB filters 23R, 23G and 23B in this basic array pattern are 8 pixels, 20 pixels and 8 pixels, respectively. That is, the ratios of the numbers of pixels of the RGB pixels are 2:5:2, and the ratio of the number of pixels of G pixels which contributes the most to acquisition of a brightness signal is greater than ratios of the numbers of pixels of R pixels and B pixels of other colors.

As described above, the ratios of the number of pixels of G pixels and the numbers of pixels of R and B pixels are different and in particular the ratio of the number of pixels of G pixels which contribute the most to acquisition of a brightness signal is greater than the ratios of the numbers of pixels of R and B pixels, so that it is possible to suppress aliasing upon demosaicing processing and it is also possible to enhance high frequency reproducibility.

### [Feature (4)]

In the color filter array illustrated in Figure 3, one or more of the R filters 23R and B filters 23B corresponding to two or more colors of other colors (R and B colors in the present embodiment) except for the above-mentioned G color are arranged on each filter line in the horizontal and vertical directions of the color filter array in each basic array pattern P.

The R filters 23R and the B filters 23B are each arranged on each filter line in the horizontal and vertical directions of the color filter array, so that it is possible to suppress generation of color moire (false color). Consequently, it is possible to prevent an optical low pass filter which suppresses generation of a false color from being arranged on an optical path from an incident surface to the imaging plane in the optical system, or to apply an optical low pass filter whose function of cutting a high frequency component for preventing generation of a false color is weak even when the optical low pass filter is applied, and thus it is possible to prevent the resolution from lowering.

Figure 4 illustrates a state where the basic array pattern P illustrated in Figure 3 is divided by four into 3 × 3 pixels.

As illustrated in Figure 4, the basic array pattern P can also be regarded as an array in which A arrays 24a of 3 × 3 pixels surrounded by solid lines in the figure and B arrays 24b of 3 × 3 pixels surrounded by broken lines in the figure are alternately arranged in the horizontal and vertical directions.

Each of the A arrays 24a and the B arrays 24b has the G filters 23G, which are brightness pixels, arranged at four corners and in the center along both diagonal lines. Further, in the A array 24a, the R filters 23R are arrayed in the horizontal direction across the center G filter 23G, and the B filters 23B are arrayed in the vertical direction. Meanwhile, in the B array 24b, the B filters 23B are arrayed in the horizontal direction across the center G filter 23G, and the R filters 23R are arrayed in the vertical direction. That is, although a positional relationship between the R filters 23R and the B filters 23B is reversed between the A array 24a and the B array 24b, other arrangement is the same.

Further, the A arrays and the B arrays are alternately arranged in the horizontal and vertical directions as illustrated in Figure 5, so that the G filters 23G at the four corners in the A array 24a and the B array 24b make up the G filters 23G of square arrays corresponding to 2 × 2 pixels.

This is because the G filters 23G which are brightness pixels are arranged at four corners and in the center of 3 × 3 pixels of the A array 24a or the B array 24b, and these 3 × 3 pixels are alternately arranged in the horizontal direction and the vertical direction to form the G filters 23G of the square arrays corresponding to 2 × 2 pixels. Note that by making this array, the above-mentioned features (1), (2) and (3), as well as the feature (5) described below are satisfied.

### [Feature (5)]

The color filter array illustrated in Figure 3 includes a square array 25 corresponding to 2 × 2 pixels provided with the G filters 23G (hereinafter simply referred to as G square array 25, see Figure 6).

As illustrated in Figure 6, by extracting 2 × 2 pixels provided with the G filters 23G, and calculating a differential absolute value of pixel values of G pixels in the horizontal direction, a differential absolute value of pixel values of G pixels in the vertical direction and a differential absolute value of pixel values of G pixels in the diagonal directions (diagonal upper right and diagonal lower right directions), it is possible to determine that there is a correlation in a direction of a small differential absolute value among the horizontal direction, the vertical direction and the diagonal directions.

That is, according to this color filter array, it is possible to determine a direction of a high correlation among the horizontal direction, the vertical direction and the diagonal directions using information of G pixels of a minimum pixel interval. This direction determination result can be used for processing of interpolating pixels from surrounding pixels (demosaicing processing). Consequently, the image processing unit 16 can execute the demosaicing processing.

Further, as illustrated in Figure 5, when pixels of the A array 24a or the B array 24b of 3 × 3 pixels are target pixels of the demosaicing processing, and 5 × 5 pixels (a local region of a mosaic image) are extracted around the A array 24a or the B array 24b, there are G pixels of 2 × 2 pixels at four corners of this 5 × 5 pixels. By using these pixel values of G pixels of 2 × 2 pixels, it is possible to precisely determine a correlation direction of four directions using information of G pixels of a minimum pixel interval.

### [Feature (6)]

The basic array pattern P of the color filter array illustrated in Figure 3 is point-symmetric with respect to the center of the basic array pattern P (the center of the four G filters 23G). Further, as illustrated in Figure 4, also the A array 24a and the B array 24b in the basic array pattern P are each point-symmetric with respect to the center G filters 23G.

This symmetry allows a circuit scale of a processing circuit at a subsequent stage to be miniaturized or simplified.

In the basic array pattern P indicated by a bold frame as illustrated in Figure 7, color filter arrays in the first and third lines out of the first to sixth lines in the horizontal direction are GBGGRG, a color filter array of the second line is RGRBGB, color filter arrays of the fourth and sixth lines are GRGGBG, and a color filter array of the fifth line is BGBRGR.

Now, in Figure 7, when a basic array pattern shifted by one pixel from the basic array pattern P in the horizontal direction and the vertical direction is Pa and a basic array pattern shifted by two pixels is Pb, even if these basic array patterns Pa and Pb are repeatedly arranged in the horizontal direction and the vertical direction, the same color filter array is provided.

That is, there are a plurality of basic array patterns which can form the color filter array illustrated in Figure 7 by repeatedly arranging basic array patterns in the horizontal direction and the vertical direction. In the first embodiment, the basic array pattern P whose basic array pattern is point-symmetric is referred to as a basic array pattern for the sake of convenience.

Note that although color filter arrays according to other embodiments described below also include a plurality of basic array patterns for each color filter array, a representative one is referred to as a basic array pattern of the color filter array.

### [Color Imaging Element according to Second Embodiment]

Figure 8 is a view illustrating a single-plate color imaging element according to a second embodiment of the present invention and, in particular, illustrates a color filter array of the color imaging element. The color imaging element according to the second embodiment employs basically the same configuration as the configuration in the above-mentioned first embodiment except that color filter array is different. Therefore, the same functions and configurations as the functions and the configurations of the above-mentioned first embodiment are assigned the same reference numerals, and descriptions thereof are omitted.

A color filter array of a color imaging element 26 according to the second embodiment (hereinafter simply referred to as a color filter array) is formed with sub arrays in which the RGB filters 23R, 23G and 23B are arrayed according to an array pattern corresponding to 4 × 4 pixels. The sub arrays according to the present embodiment include two types of arrays which are an A array 27a and a B array 27b. Note that Figure 8 is a view showing a partially extracted color filter arrays (the same applies to Figure 9 and subsequent figures).

The color filter array includes a plurality of sub array groups 28 formed by alternately arranging the A arrays 27a and the B arrays 27b in the horizontal direction, and is formed by repeatedly arranging each sub array group 28 in the vertical direction. Further, in this color filter array, the sub array groups 28 which are mutually adjacent in the vertical direction are arranged by being shifted by one pixel interval in the horizontal direction.

Furthermore, in the present embodiment, the even-numbered arranged sub array groups 28 are arranged by being shifted by one pixel interval in the vertical direction from the odd-numbered sub array groups 28 arranged in the vertical direction. Consequently, the directions to shift each sub array group 28 are mutually alternate along the vertical direction of the color filter array. Specifically, for example, in the vertical direction, the second sub array group 28 is shifted to the right direction in the figure from the first sub array group 28, and the third sub array group 28 is shifted to the left direction in the figure from this second sub array group 28, and subsequently the shifting directions are switched in the same way to the right, to the left, and to the right ....

In the A array 27a, the G filters 23G are arranged along two diagonal lines of the A array 27a. Further, in the A array 27a, the R filter 23R and the B filter 23B are arranged one by one on each filter line of the color filter array in the horizontal and vertical directions. Meanwhile, the B array 27b is basically the same array pattern as the A array 27a except that a positional relationship between the R filter 23R and the B filter 23B is reversed.

This color filter array can also be regarded as an array in which basic array patterns P1 (a pattern indicated by a bold frame in the figure) formed with square array patterns corresponding to 8 × 8 pixels are arranged in each of the horizontal and vertical directions. This basic array pattern P1 includes sub arrays (at least one of the A arrays 27a and the B arrays 27b) included in each of the mutually adjacent sub array groups 28.

As illustrated in Figure 9, the color filter array illustrated in Figure 8 is obtained by repeatedly arranging the basic array patterns P1 in the horizontal and vertical directions. Hence, the color filter array includes the above-mentioned feature (1).

In this regard, basic array patterns of the color filter array are not limited to the basic array patterns P1 illustrated in Figure 9, and are not particularly limited as long as the basic array patterns are square array patterns corresponding to 8 × 8 pixels. Even when, for example, basic array patterns P1a (displayed by dotted line frames in Figure 8) formed by shifting the basic array pattern P1 illustrated in Figure 8 by two pixels in the horizontal direction and by one pixel in the vertical direction are repeatedly arranged in the horizontal and vertical directions as illustrated in Figure 10, the color filter array illustrated in Figure 8 can be acquired. Thus, the color filter array is formed by repeatedly arranging arbitrary basic array patterns corresponding to 8 × 8 pixels in the horizontal and vertical directions. Hereinafter, reference character "P1" is assigned to a basic array pattern in the second embodiment.

Back to Figure 8, when the A array 27a and the B array 27b include array patterns corresponding to N × N (N is an even number of 4 or more, a case of N = 2 is described below) pixels (condition 1), the G filters 23G are arranged on at least two diagonal lines of both of the arrays 27a and 27b (condition 2) and the mutually adjacent sub array groups 28 are arranged by being shifted by one pixel interval (condition 3), the G filters 23G are arranged on each filter line in the horizontal, vertical and diagonal (NE, NW) directions of the color filter array.

Meanwhile, when the condition 1 and the condition 2 are satisfied but the condition 3 is not satisfied as in a comparative example illustrated in Figure 11, although the color filter array can be regarded as an array formed by arraying basic array patterns P_{NG}, the pixels on which the G filters 23G are not arranged (herein after referred to as G empty pixels) in each sub array (both of the arrays 27a and 27b) are positioned on the same line in the diagonal (NE, NW) direction. As a result, diagonal line L on which the G filters 23G are not arranged (hereinafter referred to as G empty line) are produced in the color filter array.

By contrast with this, as illustrated in Figure 12, mutually adjacent sub array groups 28 are arranged by being shifted by one pixel interval in the horizontal direction in the present embodiment, and therefore at least one G filter 23G in a sub array of another sub array group 28 is arranged on an extended line of the G empty line L in the sub array of one sub array group 28. As a result, the G empty line L, such as the one in the comparative example illustrated in Figure 11, is not produced.

Further, the G filters 23G are arrayed to satisfy the above-mentioned condition 2, one or more of the G filters 23G are arranged on each filter line in the horizontal and vertical directions of the color filter array. Thus, in the second embodiment, by arraying the G filters 23G to satisfy the above-mentioned conditions 1 to 3, the G filters 23G are arranged on each filter line in the horizontal, vertical and diagonal (NE, NW) directions of the color filter array. Consequently, the color filter array includes the above-mentioned feature (2).

Further, when the above-mentioned condition 2 is satisfied, the color filter array includes the G square arrays 25. Consequently, the color filter array includes the above-mentioned feature (5).

Back to Figure 8, the R filter 23R and the B filter 23B are arranged on each filter line in the horizontal and vertical directions of the color filter array in each sub array (both of the arrays 27a and 27b). Hence, even in the arbitrary basic array pattern P1, the R filter 23R and the B filter 23B are arranged on each filter line in the horizontal and vertical directions of the color filter array. Hence, the color filter array includes the above-mentioned feature (4).

Further, in the second embodiment, the numbers of pixels of R pixels, G pixels and B pixels (abbreviated as the numbers of pixels of RGB pixels when necessary) corresponding to the RGB filters 23R, 23B and 23R in the basic array pattern P1 are 16 pixels, 32 pixels and 16 pixels. Hence, the ratios of the numbers of pixels of RGB pixels are 1:2:1, and therefore the color filter array includes the above-mentioned feature (3).

Note that the basic array pattern P1 is not point-symmetric with respect to its center.

As described above, the color filter array according to the second embodiment includes the same features as the features (1), (2), (3), (4) and (5) of the color filter array according to the first embodiment.

Further, the basic array pattern P1 is formed with an array pattern corresponding to "even number × even number" pixels, so that, when the color imaging element 26 is a CMOS imaging element, one amplifier circuit can be shared among four pixels arranged in a square grid pattern (the same applies to other embodiments).

### [Color Imaging Element according to Third Embodiment]

Figure 13 is a view illustrating a single-plate color imaging element according to a third embodiment of the present invention and, in particular, illustrates a color filter array of the color imaging element. In the above-mentioned second embodiment, the mutually adjacent sub array groups 28 are arranged by being shifted by one pixel interval in the horizontal direction. By contrast with this, in a color imaging element 30 according to the third embodiment, the mutually adjacent sub array groups 28 are arranged by being shifted by two pixel intervals in the horizontal direction.

Note that configurations according to the third embodiment are basically the same as the configurations in the above-mentioned first and second embodiments except that a shift amount of the mutually adjacent sub array groups 28 is different, and therefore the same functions and configurations according to each of these embodiments are assigned the same reference numerals, and descriptions thereof are omitted (the same applies to each embodiment subsequent to a fourth embodiment).

A color filter array of the color imaging element 30 (hereinafter simply referred to as a color filter array) can also be regarded as an array in which basic array patterns P2 formed with square array patterns corresponding to 8 × 8 pixels are arranged in each of the horizontal and vertical directions, similar to the second embodiment. Note that the basic array pattern P2 is not limited to an array pattern illustrated in Figure 13, and an arbitrary square array pattern corresponding to 8 × 8 pixels can be used as a basic array pattern. As a result, the color filter array includes the above-mentioned feature (1).

Even when the mutually adjacent sub array groups 28 are arranged by being shifted by two pixel intervals (condition 3A), no diagonal (NE, NW) line on which the G filters 23G are not arranged is produced in the color filter array. Further, the above-mentioned condition 2 is satisfied, so that no horizontal and vertical lines on which the G filters 23G are not arranged are produced in the color filter array. Furthermore, the color filter array includes the G square arrays 25. Consequently, the color filter array includes the above-mentioned feature (2) and feature (5).

The R filter 23R and the B filter 23B are arranged, similar to the second embodiment, on each filter line in the horizontal and vertical directions of the color filter array in each sub array. Hence, even in the arbitrary basic array pattern P2, the R filter 23R and B filter 23B are arranged on each filter line in the horizontal and vertical directions of the color filter array. Consequently, the color filter array includes the above-mentioned feature (4). Further, the ratios of the numbers of pixels of, RGB pixels are the same as the ratios in the second embodiment, and therefore the color filter array satisfies the above-mentioned feature (3).

Note that the basic array pattern P2 is not point-symmetric with respect to its the center, similar to the second embodiment.

As described above, the color filter array according to the third embodiment includes the same features as the features (1), (2), (3), (4) and (5) of the color filter array according to the first embodiment.

### [Color Imaging Element according to Fourth Embodiment]

Figure 14 is a view illustrating a single-plate color imaging element according to the fourth embodiment of the present invention and, in particular, illustrates a color filter array of the color imaging element. In the above-mentioned second and third embodiments, the sub array groups 28 which are mutually adjacent in the vertical direction are arranged by being shifted in the horizontal direction. By contrast with this, in a color imaging element 32 according to the fourth embodiment, sub array groups which are mutually adjacent in the horizontal direction are arranged by being shifted in the vertical direction.

A color filter array of the color imaging element 32 (hereinafter simply referred to as a color filter array) includes a plurality of sub array groups 33 formed by alternately arraying the A arrays 27a and the B arrays 27b in the vertical direction, and is formed by repeatedly arranging each sub array group 33 in the horizontal direction.

Further, in the color filter array, the sub array groups 33 which are mutually adjacent in the horizontal direction are arranged by being shifted by one pixel interval in the vertical direction. Specifically, the even-numbered arranged sub array groups 33 are arranged by being shifted by one pixel interval in the same direction from the odd-numbered sub array groups 33 arranged in the horizontal direction. Consequently, directions to shift each sub array group 33 are mutually alternate along the horizontal direction of the color filter array.

Such a color filter array can also be regarded as an array in which basic array patterns P3 which are square array patterns corresponding to 8 × 8 pixels are arranged in each of the horizontal and vertical directions. Note that the basic array pattern P3 is not limited to the array pattern illustrated in Figure 14, and an arbitrary square array pattern corresponding to the 8 × 8 pixels can be used as a basic array pattern. As a result, the color filter array includes the above-mentioned feature (1).

Further, the color filter array differs from the color filer array of the second embodiment in the direction to shift the mutually adjacent sub array groups 33, but is the same as the color filer array of the second embodiment in that mutually adjacent sub array groups are shifted by one pixel interval. Hence, the color filter array satisfies the above-mentioned condition 1, condition 2 and condition 3, so that the G filters 23G are arranged on each filter line in the horizontal, vertical and diagonal (NE, NW) directions of the color filter array. Further, the color filter array includes the G square arrays 25. Consequently, the color filter array includes the above-mentioned feature (2) and feature (5).

Similar to the second embodiment, the R filter 23R and the B filter 23B are arranged on each filter line in the horizontal and vertical directions of the color filter array in each sub array (the A array 27a and the B array 27b), and thus even in the arbitrary basic array pattern P3, the R filter 23R and the B filter 23B are arranged on each filter line in the horizontal and vertical directions of the color filter array. Consequently, the color filter array includes the above-mentioned feature (4). Further, the ratios of the numbers of pixels of RGB pixels are the same as the ratios in the second embodiment, so that the color filter array satisfies the above-mentioned feature (3).

Note that the basic array pattern P3 is not point-symmetric with respect to its center.

As described above, the color filter array according to the fourth embodiment includes the same features as the features (1), (2), (3), (4) and (5) of the color filter array according to the first embodiment.

### [Color Imaging Element according to Fifth Embodiment]

Figure 15 is a view illustrating a single-plate color imaging element according to a fifth embodiment of the present invention and, in particular, illustrates a color filter array of the color imaging element. In the above-mentioned fourth embodiment, the sub array groups 33 which are mutually adjacent in the horizontal direction are arranged by being shifted by one pixel interval in the vertical direction. By contrast with this, in a color imaging element 36 according to the fifth embodiment, the mutually adjacent sub array groups 33 are arranged by being shifted by two pixel intervals in the vertical direction.

Similar to the fourth embodiment, the color filter array of the color imaging element 36 (hereinafter simply referred to as a color filter array) can also be regarded as an array in which basic array patterns P4 formed with arbitrary square array patterns corresponding to 8 × 8 pixels are arranged in each of the horizontal and vertical directions. As a result, the color filter array includes the above-mentioned feature (1).

Further, the color filter array is basically the same as the color filter array according to the fourth embodiment except that the mutually adjacent sub array groups 33 are shifted by two pixel intervals in the horizontal direction. Hence, the color filter array includes the G square arrays 25, and the R filters 23R and the B filters 23B are each arranged on each filter line in the horizontal and vertical directions of the color filter array in the arbitrary basic array pattern P4. Further, the ratios of the numbers of pixels of RGB pixels are 1:2:1. Consequently, the color filter array includes the above-mentioned features (5), (4) and (3).

Further, the color filter array differs from the color filter array according to the third embodiment in the direction to shift the mutually adjacent sub array groups 33, but is the same as the color filter array according to the third embodiment in that mutually adjacent sub array groups are shifted by two pixel intervals. Hence, the color filter array satisfies the above-mentioned condition 1, condition 2 and condition 3A, and the G filters 23G are arranged on each filter line in the horizontal, vertical and diagonal (NE, NW) directions of the color filter array. Consequently, the color filter array includes the above-mentioned feature (2).

Note that the basic array pattern P4 is not point-symmetric with respect to its center.

As described above, the color filter array according to the fifth embodiment includes the same features as the features (1), (2), (3), (4) and (5) of the color filter array according to the first embodiment.

### [Color Imaging Element according to Sixth Embodiment]

Figure 16 is a view illustrating a single-plate color imaging element according to a sixth embodiment of the present invention and, in particular, illustrates a color filter array of the color imaging element. The color filter arrays according to the above-mentioned second to fifth embodiments are formed with sub arrays (the A arrays 27a and the B arrays 27b) which include the square array patterns corresponding to 4 × 4 pixels. By contrast with this, the color filter array of a color imaging element 39 according to the sixth embodiment (hereinafter simply referred to as a color filter array) is formed with sub arrays including square array patterns corresponding to 2 × 2 pixels.

The color filter array includes sub array groups 41a formed by alternately arraying A arrays 40a and B arrays 40b in the horizontal direction and sub array groups 41b formed by alternately arraying C arrays 40c and D arrays 40d in the horizontal direction, and is formed by alternately arranging the sub array groups 41a and the sub array groups 41b in the vertical direction. Further, in this color filter array, the sub array groups 41 a and the sub array groups 41 b which are mutually adjacent in the vertical direction are arranged by being mutually shifted by one pixel interval in the horizontal direction.

In the A array 40a, out of its two diagonal lines, the G filters 23G are arranged along the diagonal line in a diagonal left (NW) direction, and the B filters 23B are arranged along the diagonal line in a diagonal right (NE) direction. Further, the B array 40b is formed by replacing the B filters 23B of the A array 40a with the R filters 23R.

In the C array 40c, the G filters 23G are arranged along a diagonal line in the diagonal left (NW) direction, and the B filter 23B and the R filter R23 are arranged one by one along the diagonal line in the diagonal right (NE) direction. Further, the D array 40d is formed by reversing a positional relationship between the R filter 23R and the B filter 23B of the C array 40c.

The color filter array employing the above-mentioned configuration can also be regarded as an array in which basic array patterns P5, which are square array patterns corresponding to 4 × 4 pixels, are arranged in each of the horizontal and vertical directions. Note that, similar to the above-mentioned second embodiment, the basic array pattern P5 is not limited to the array pattern illustrated in Figure 16, and an arbitrary square array pattern corresponding to 4 × 4 pixels can be used as a basic array pattern. As a result, the color filter array includes the above-mentioned feature (1).

Further, the color filter array satisfies a condition 1A that each of the arrays 40a to 40d includes an array pattern corresponding to 2 × 2 pixels, a condition 2A that the G filters 23G are arranged on one of two diagonal lines of each of the arrays 40a to 40d and the above-mentioned condition 3 that the mutually adjacent sub array group 41 a and sub array group 41b are arranged by being shifted by one pixel interval.

When the condition 1A and condition 2A are satisfied, the G filters 23G are arranged one by one on each of the horizontal and vertical lines in each of the arrays 40a to 40d, and thus the G filters 23 are arranged on each filter line in the horizontal and vertical directions of the color filter array. In this case, when only the conditions 1A and 2A are satisfied, the G filters 23G are arranged in a checkered pattern, and accordingly lines on which the G filters 23G are not arranged are generated in the diagonal directions (NE, NW) in the color filter array. However, when the condition 3 is further satisfied, the G filters 23G are arranged on each filter line in the diagonal (NE, NW) directions of the color filter array. Consequently, the color filter array includes the above-mentioned feature (2).

Further, in the color filter array employing the above-mentioned configuration, the R filter 23R and the B filter 23B are each arranged on each filter line in the horizontal and vertical directions of the color filter array in the arbitrary basic array pattern P5. Consequently, the color filer array includes the above-mentioned feature (4). Further, the numbers of pixels of RGB pixels corresponding to the RGB filters 23R, 23B and 23R in the arbitrary basic array pattern P5 are 4 pixels, 8 pixels and 4 pixels. Hence, the ratios of the numbers of pixels of RGB pixels are 1:2:1, and the color filter array includes the above-mentioned feature (3).

Note that the basic array pattern P5 is not point-symmetric with respect to its center, and the G square array 25 is not included in the color filter array.

As described above, the color filter array according to the sixth embodiment includes the same features as the features (1), (2), (3) and (4) according to the first embodiment.

Further, the color filter array according to the sixth embodiment becomes an array in which basic array patterns P5a are repeatedly arranged in the horizontal and vertical directions as indicated by a C portion in Figure 17 when odd-numbered (or may be even-numbered) lines of the color imaging element 39 are thinned, read and driven as indicated by an A portion and a B portion in Figure 17. Hence, even when the color imaging element 39 is thinned, read and driven upon imaging of moving images or the like, it is possible to perform demosaicing processing or the like according to a repetition pattern of the RGB filters 23R, 23G and 23B.

### [Color Imaging Element according to Seventh Embodiment]

Figure 18 is a view illustrating a single-plate color imaging element according to the seventh embodiment of the present invention and, in particular, illustrates a color filter array of the color imaging element. Although, in the above-mentioned sixth embodiment, the G filters 23G are arranged along a diagonal line in the diagonal left (NW) direction in each of the arrays 40a to 40d, the G filters 23G may be arranged along diagonal lines in the diagonal right (NE) direction in A, B, C and D arrays 46a to 46d as in the color imaging element 45 according to the seventh embodiment.

Each of the arrays 46a to 46d has the same pattern as the array in which each of the arrays 40a to 40d according to the above-mentioned sixth embodiment is rotated 90° in the clockwise direction in Figure 16. The color filter array formed with each of these arrays 46a to 46d has basically the same array pattern as the color filter array according to the sixth embodiment except that an arrangement of the G filters 23G is reversed.

Further, the basic array pattern P6 included in the color filter array is also basically the same array pattern as the basic array pattern P5 according to the sixth embodiment except that an arrangement of the G filters 23G is reversed. Hence, the color filter array according to the seventh embodiment also includes the same features as the features (1), (2), (3) and (4) according to the first embodiment.

Further, the color filter array becomes an array in which basic array patterns P6a are repeatedly arranged in the horizontal and vertical directions similar to the sixth embodiment when odd-numbered (or maybe even-numbered) lines of the color imaging element 45 are thinned, read and driven as indicated by an A portion to a C portion in Figure 19.

### [Color Imaging Element according to Eighth Embodiment]

Figure 20 is a view illustrating a single-plate color imaging element according to an eighth embodiment of the present invention and, in particular, illustrates a color filter array of the color imaging element. Although the color filter arrays according to the above-mentioned second to fifth embodiments are formed with sub arrays including square array patterns corresponding to 4 × 4 pixels, sizes of the sub arrays are further enlarged in a color imaging element 48 according to the eighth embodiment.

The color filter array of the color imaging element 48 (hereinafter simply referred to as a color filter array) is formed with sub arrays including square array patterns corresponding to 6 × 6 pixels, specifically, A arrays 49a and B arrays 49b. In this color filter array, the A arrays 28a and the B arrays 28b of the color filter array according to the second embodiment are replaced with the A arrays 49a and the B arrays 49b, respectively. Hence, in the color filter array, sub array groups 50 formed by mutually arraying the A arrays 49a and the B arrays 49b in the horizontal direction are repeatedly arranged in the vertical direction. Further, similar to the second embodiment, the mutually adjacent sub array groups 50 are arranged by being shifted by one pixel interval in the horizontal direction.

In the A arrays 49a and the B arrays 49b, the G filters 23G are arranged along the two diagonal lines, and the R filter 23R and the B filter 23B are arranged one by one on each filter line in the horizontal and vertical directions of the color filter array. In this regard, in the A arrays 49a and the B array 49b, the G filters 23G are also arranged at portions other than the diagonal lines such that the number of the G filters 23G is greater than the numbers of R and B filters 23R and 23B.

This color filter array can also be regarded as an array in which basic array patterns P7 formed with square array patterns corresponding to 12 × 12 pixels are arranged in each of the horizontal and vertical directions, similar to the above-mentioned second embodiment and so on. Further, this color filter array is basically the same as the color filter array according to the second embodiment except that sizes of sub arrays (the A arrays 49a and the B arrays 49b) are enlarged, and consequently includes the above-mentioned features (1), (2), (4) and (5), similar to the color filter array according to the second embodiment.

Furthermore, the numbers of pixels of RGB pixels corresponding to the RGB filters 23R, 23B and 23R in the basic array pattern P7 are 32 pixels, 80 pixels and 32 pixels. Hence, the ratios of the numbers of pixels of RGB pixels are 2:5:2, and the color filter array includes the above-mentioned feature (3).

Note that the basic array pattern P7 is not point-symmetric with respect to its center.

As described above, the color filter array according to the eighth embodiment includes the same features as the features (1), (2), (3), (4) and (5) of the color filter array according to the first embodiment.

Note that even when the color filter array is formed with sub arrays including an array pattern corresponding to N × N (N is an even number) pixels of 8 × 8 pixels or more, if sub array groups which are mutually adjacent in the vertical or horizontal direction are arranged by being shifted by M pixel intervals from each other to the horizontal or vertical direction, the color filter array includes the same feature as the feature of the above-mentioned second embodiment. In this case, the basic array pattern is an arbitrary square array pattern corresponding to 2N × 2N pixels. In this regard, M is adequately set according to sizes of sub arrays such that the G filters 23G are arranged on each filter line in the horizontal, vertical and diagonal (NE, NW) directions of the color filter array.

Further, N is preferably 10 or less when enlarging the sizes of the sub arrays. This is because, when N exceeds 10 (N > 10), while signal processing such as demosaicing processing becomes complicated, a special effect cannot be obtained by increasing sizes of the basic array patterns.

### [Color Imaging Element according to Ninth Embodiment]

Figure 21 is a view illustrating a single-plate color imaging element according to a ninth embodiment of the present invention and, in particular, illustrates a color filter array of the color imaging element. In the above-mentioned second to eighth embodiments, sub array groups which are adjacent in the vertical direction or the horizontal direction are arranged by being shifted by M pixel intervals, so that the color filter array includes at least the features (1), (2), (3) and (4) of the color filter array according to the first embodiment. By contrast with this, in a color imaging element 52 according to the ninth embodiment, by shifting positions of the G filters 23G in mutually adjacent sub arrays, it is possible to provide the same effect as the effects in the above-mentioned second to eighth embodiments.

The color filter array of the color imaging element 52 (hereinafter simply referred to as a color filter array) includes a basic array pattern P8 in which RGB filters 23R, 23G and 23B are arranged according to an array pattern corresponding to 8 × 8 pixels, and this basic array pattern P8 is repeatedly arranged in the horizontal direction and the vertical direction. Hence, the color filter array includes the above-mentioned feature (1).

The basic array pattern P8 is formed with four types of sub arrays including array patterns corresponding to 4 × 4 pixels. These four types of sub arrays are an A array 53a, a B array 53b, a C array 53c and a D array 53d, and each of the arrays 53a to 53d is arranged in a grid pattern to be mutually adjacent in the horizontal and vertical directions. Specifically, the A array 53a and the B array 53b, as well as, the C array 53c and the D array 53d are each adjacent in the vertical direction. Further, the A array 53a and the C array 53c, as well as, the B array 53b and the D array 53d are each adjacent in the horizontal direction.

The A array 53a and the D array 53d are the same as the B array 27b (or maybe the array 27a) according to the second embodiment. In the B array 53b and the C array 53c, the G filters 23G are arranged at positions shifted by one pixel interval in the vertical direction from two diagonal lines. Further, in the B array 53b and the C array 53c, one or more of the R filters 23R and B filters 23B are arranged on each filter line in the horizontal and vertical directions of the color filter array.

Thus, when each of the arrays 53a to 53d satisfies the above-mentioned condition 1, and the G filters 23G are arranged along at least two diagonal lines in one of those of the arrays 53a to 53d that are mutually adjacent in the horizontal direction or the vertical direction (condition 4), and an arrangement of one G filter 23G is provided at a position shifted by Q (Q < N) pixel intervals from the arrangement of the other G filter 23G (condition 5), the G filters 23G are arranged on each filter line in the horizontal, vertical and diagonal (NE, NW) directions of the color filter array. Consequently, the color filter array includes the above-mentioned feature (2).

Further, when the above-mentioned condition 4 is satisfied, the color filter array includes the G square arrays 25. Consequently, the color filter array includes the above-mentioned feature (5).

The R filter 23R and the B filter 23B are arranged on each filter line in the horizontal and vertical directions of the color filter array in each sub array (each of the arrays 53a to 53d). Hence, even in the basic array pattern P8, the R filter 23R and the B filter 23B are arranged on each filter line in the horizontal and vertical directions of the color filter array. Hence, the color filter array includes the above-mentioned feature (4).

Further, in the ninth embodiment, the numbers of pixels of RGB pixels corresponding to the RGB filters 23R, 23B and 23R in the basic array pattern P8 are 18 pixels, 28 pixels and 18 pixels. Hence, the ratios of the numbers of pixels of RGB pixels are 1:1.6:1, and the color filter array includes the above-mentioned feature (3).

Note that the basic array pattern P8 is not point-symmetric with respect to its center.

As described above, the color filter array according to the ninth embodiment includes the same features as the features (1), (2), (3), (4) and (5) of the color filter array according to the first embodiment.

Note that in the color filter array according to the above-mentioned ninth embodiment, although the arrangements of the G filters 23G in the B array 53b and the C array 53c are shifted by one pixel interval to the upper direction in the figure from the arrangements of the G filters 23G in the A array 53a and the D array 53d, the arrangement may be shifted by one pixel interval to a lower direction in the figure or to a left or a right direction (horizontal direction) in the figure.

### [Color Imaging Element according to Tenth Embodiment]

Figure 22 is a view illustrating a single-plate color imaging element according to a tenth embodiment of the present invention and, in particular, illustrates a color filter array of the color imaging element. In the above-mentioned ninth embodiment, the arrangements of the G filters 23G in the B array 53b and the C array 53c are shifted in the same direction from the arrangements of the G filters 23G in the A array 53a and the D array 53d. By contrast with this, in a color imaging element 55 according to the tenth embodiment, directions to shift the arrangements of the G filters 23G in the B array and the C array are different.

The color filter array of the color imaging element 55 (hereinafter simply referred to as a color filter array) includes a basic array pattern P9 formed by arraying RGB filters 23R, 23G and 23B according to an array pattern corresponding to 8 × 8 pixels, and this basic array pattern P9 is repeatedly arranged in the horizontal direction and the vertical direction. Hence, the color filter array includes the above-mentioned feature (1).

The basic array pattern P9 is basically the same pattern as the basic array pattern P8 according to the ninth embodiment. However, the basic array pattern P9 includes a B array 53b1 and a C array 53c1 which are different from the B array 53b and the C array 53c of the basic array pattern P8, respectively.

The arrangement of the G filters 23G in the B array 53b1 is shifted by one pixel interval to the right direction (horizontal direction) in the figure from the arrangements of the G filters 23G in the A array 53a and the D array 53d. Meanwhile, the arrangement of the G filters 23G in the C array 53c1 is shifted by one pixel interval to the left direction (horizontal direction) in the figure from the arrangements of the G filters 23G in the A array 53a and the D array 53d.

Thus, even when each of the arrays 53a, 53b1, 53c1 and 53d satisfies the above-mentioned condition 1 and condition 4, and when the arrangements of the G filters 23G in the B array 53b and the C array 53c are provided at positions each shifted by Q (Q < N) pixel intervals to the different directions from the arrangements of the G filters 23G in the A array 53a and the D array 53d (condition 5A), the G filters 23G are arranged on each filter line in the horizontal, vertical and diagonal (NE, NW) directions of the color filter array. Consequently, the color filter array includes the above-mentioned feature (2). Further, the color filter array includes the G square array 25, and accordingly includes the above-mentioned feature (5).

Similar to the ninth embodiment, the R filter 23R and the B filter 23B are arranged on each filter line in the horizontal and vertical directions of the color filter array in the basic array pattern P9. Hence, the color filter array includes the above-mentioned feature (4).

Further, the ratios of the numbers of pixels of RGB pixels are the same as the ratios in the ninth embodiment, and accordingly the color filter array includes the above-mentioned feature (3).

Note that the basic array pattern P9 is not point-symmetric with respect to its center.

As described above, the color filter array according to the tenth embodiment includes the same features as the features (1), (2), (3), (4) and (5) of the color filter array according to the first embodiment.

Note that, in the color filter array according to the above-mentioned tenth embodiment, although the arrangements of the G filters 23G in the B array 53b1 and the C array 53c1 are shifted by one pixel interval to the right direction and to the left direction in the figure, respectively, from the arrangements of the G filters 23G in the A array 53a and the D array 53d, the directions to shift the arrangements may be adequately changed as long as the color filter array includes the above-mentioned feature (2). Further, the arrangement of the G filters 23G in one of the B array 53b1 and the C array 53c1 may be shifted in the horizontal direction, and the arrangement of the G filters 23G in the other one may be shifted to the vertical direction.

### [Color Imaging Element according to Eleventh Embodiment]

Figure 23 is a view illustrating a single-plate color imaging element according to an eleventh embodiment of the present invention and, in particular, illustrates a color filter array of the color imaging element. Although basic array patterns P8 and P9 according to the above-mentioned ninth and tenth embodiments are formed with sub arrays including square array patterns corresponding to 4 × 4 pixels, sizes of sub arrays are further enlarged in a color imaging element 57 according to the eleventh embodiment.

The color filter array of the color imaging element 57 (hereinafter simply referred to as a color filter array) includes a basic array pattern P10 in which the RGB filters 23R, 23G and 23B are arrayed according to an array pattern corresponding to 12 × 12 pixels, and this basic array patterns P10 is repeatedly arranged in the horizontal direction and the vertical direction. Hence, the color filter array includes the above-mentioned feature (1).

Similar to the above-mentioned ninth and tenth embodiments, the basic array pattern P10 is formed with an A array 58a, a B array 58b, a C array 58c and a D array 58d arranged in a grid pattern to be mutually adjacent in the horizontal and vertical directions. In each of the arrays 58a to 58d, the RGB filters 23R, 23G and 23B are arrayed according to the array pattern corresponding to 6 × 6 pixels.

Each of the arrays 58a to 58d is basically the same as each of the arrays 53a, 53b1, 53c1 and 53d according to the tenth embodiment except that individual sizes are enlarged, the G filters 23G are arranged at portions other than diagonal lines in the A array 58a and the D array 58d, and a direction to shift the B array 58b is changed to the upper direction in the figure. Hence, the color filter array includes the above-mentioned features (2), (4) and (5), similar to the tenth embodiment.

Further, the numbers of pixels of RGB pixels corresponding to the RGB filters 23R, 23B and 23R in the basic array pattern P10 are 36 pixels, 72 pixels and 36 pixels. Hence, the ratios of the numbers of pixels of RGB pixels are 1:2:1, and the color filter array includes the above-mentioned feature (3).

Note that the basic array pattern P10 is not point-symmetric with respect to its center.

As described above, the color filter array according to the eleventh embodiment includes the same features as the features (1), (2), (3), (4) and (5) of the color filter array according to the first embodiment.

Note that, although not illustrated, even when a basic array pattern is formed with sub arrays including an array pattern corresponding to N × N (N is an even number) of 8 × 8 pixels or more, the color filter array includes the same features as the features in the above-mentioned ninth or tenth embodiments. Meanwhile, as described above, when N exceeds 10, signal processing such as demosaicing processing becomes complicated and a special effect cannot be provided even by increasing the size of the basic array pattern, and therefore N is preferably 10 or less.

Further, in the ninth embodiment to the eleventh embodiment, although the arrangements of the G filters 23G in the B array and the C array are each shifted by one pixel interval from the arrangements of the G filters 23G in the A array and the D array, the amount to shift the arrangement of the G filters 23G may be changed in a range of 2 to Q pixel intervals as long as the color filter array includes the above-mentioned feature (2). Furthermore, the position of the A array and the D array in the color filter array, and the position of the B array and the C array may be reversed.

### [Others]

The arrangements of the R filters 23 and the B filters 23B according to each of the above-mentioned embodiments are not limited to the arrangements illustrated in Figures 3 to 23, and may be changed as long as at least the above-mentioned feature (4) is satisfied.

In the above-mentioned second to eighth embodiments, although the even-numbered arranged sub array groups are shifted in the vertical or the horizontal direction from the odd-numbered arranged sub array groups to make the direction to shift each of the sub array groups alternate along the vertical direction or the horizontal direction of the color filter array, the direction to shift each sub array group may be adequately changed as long as the color filter array includes the above-mentioned feature (2).

### [Modified Example]

Further, although, in each of the above-mentioned embodiments, the description has been made about the examples where green (G) is adopted as the first color and red (R) and blue (B) are adopted as the second color, the colors which can be used for a color filter are not limited to these colors, and a color filter corresponding to a color satisfying the following conditions can also be used.

### <Conditions of First Filter (First Color)>

Although in each embodiment, the description has been made about the example where G filter of the G color is regarded as the first filter having the first color of the present invention, a filter which satisfies one of the following conditions (1) to (4) may be used instead of the G filter or instead of part of the G filters.

### [Condition (1)]

The condition (1) is that a contribution rate for acquiring a brightness signal is 50% or more. This contribution rate 50% is a value determined to distinguish between the first color (e.g. G color) and the second color (e.g. R and B colors) of the present invention, and is a value determined so that the "first color" includes a color whose contribution rate for acquiring brightness data is relatively higher than the contribution rates of the R color and the B color or the like.

Note that the colors whose contribution rates are less than 50% are the second color (e.g. R color, B color or the like) of the present invention, and filters which have these colors are the second filters of the present invention.

### [Condition (2)]

The condition (2) is that a peak of a filter transmittance is in a range of wavelength 480 nm or more and 570 nm or less. A value measured by, for example, a spectral meter is used for the filter transmittance. This wavelength range is a range determined to distinguish between the first color (e.g. the G color) and the second color (e.g. R and B colors) of the present invention, and is a range determined not to include peaks of the R color, the B color and the like whose contribution rates described above are relatively low and to include a peak of the G color and the like whose contribution rate is relatively high. Hence, a filter whose peak of the transmittance is in the range of wavelength 480 nm or more and 570 nm or less can be used for the first filter. Note that the filters whose peaks of the transmittances are outside the range of wavelength 480 nm or more and 570 nm or less are the second filters (the R filter and the B filter)of the present invention.

### [Condition (3)]

The condition (3) is that the transmittance in a range of wavelength 500 nm or more and 560 nm or less is higher than the transmittances of the second filters (the R filter and the B filter). Again in this condition (3), a value measured by, for example, a spectral meter is used for the filter transmittance. The wavelength range of this condition (3) is a range determined to distinguish between the first color (e.g. G color) and the second color (e.g. R and B colors) of the present invention, and is a range in which the transmittance of a filter including a color whose contribution rate described above is relatively higher than the R color and the B color or the like is higher than the transmittances of the R B filters. Consequently, it is possible to use as the first filter a filter whose transmittance is relatively high in the range of wavelength 500 nm or more and 560 nm or less, and use as the second filters the filters whose transmittances are relatively low.

### [Condition (4)]

The condition (4) is to use the filters of two or more colors which include the color contributing the most to a brightness signal (e.g. the G color of RGB) out of three primary colors and a color different from these three primary colors, as the first filters. In this case, filters corresponding to colors other than each color of the first filters are the second filters.

### <A Plurality Types of First Filter (G Filter)>

Consequently, G filters of the G color as the first filter is not limited to one type, and, for example, a plurality of types of G filters (G1 filter, G2 filter) can also be used as the first filters. That is, the G filters of a color filter (basic array pattern) according to each of the above-mentioned embodiments may be adequately replaced with the G1 filters or the G2 filters. The G1 filter allows transmission of G light of a first wavelength band, and the G2 filter allows transmission of G light of a second wavelength band which is highly correlated with the G1 filter (see Figure 24).

Existing G filters (e.g. the G filters according to the first embodiment) can be used for the G1 filters. Further, filters which are highly correlated with the G1 filters can be used for the G2 filters. In this case, a peak value of a spectral sensitivity curve of a light receiving element on which the G2 filter is arranged is desirably in the range of wavelength, for example, 500 nm to 535 nm (near a peak value of a spectral sensitivity curve of the light receiving element on which the existing G filter is arranged). Note that a method described in, for example, Japanese Patent Application Laid-Open No. 2003-284084 can be used for the method of determining color filters of four colors (R, G1, G2 and B).

By setting four types of colors of an image acquired by a color imaging element and increasing pieces of color information to be acquired in this way, it is possible to more accurately express colors compared to a case where only three types of colors (RGB) are acquired. That is, it is possible to reproduce colors which seem different to the eyes as different colors and colors which seem the same to the eyes as the same colors (to enhance "the color determinability").

Note that the transmittances of the G1 and G2 filters are basically the same as the transmittance of the G filter according to the first embodiment, and the contribution rate for acquiring a brightness signal is higher than 50%. Hence, the G1 and G2 filters satisfy the above-mentioned condition (1).

Further, in Figure 24 which illustrates spectral sensitivity characteristics of a color filter array (light receiving element), a peak of the transmittance of each of the G1 and G2 filters (a peak of the sensitivity of each G pixel) is in the range of wavelength 480 nm or more and 570 nm or less. The transmittance of each of the G1 and G2 filters is higher than the transmittances of R and B filters in the range of wavelength 500 nm or more and 560 nm or less. Hence, each of the G1 and G2 filters also satisfies the above-mentioned conditions (2) and (3).

Note that the arrangement and the number of each of the G1 and G2 filters may be adequately changed. Further, types of G filters may be increased to three types or more.

### <Transparent Filter (W filter)>

Although color filters including chromatic filters corresponding to RGB colors have been mainly described in the above-mentioned embodiments, part of these chromatic filters may be transparent filters W (white pixels). The transparent filters W are preferably arranged instead of a part of the first filters (G filters) in particular. Consequently, by replacing a part of G pixels with white pixels, it is possible to suppress deterioration of color reproducibility even when a pixel size is miniaturized.

The transparent filter W is a filter of a transparent color (first color). The transparent filter W is a filter which allows transmission of light corresponding to a wavelength band of visible light, and whose transmittance of light, for example, of each color of RGB is 50% or more. The transmittance of the transparent filter W is higher than the transmittance of the G filter, and the contribution rate for acquiring a brightness signal is also higher than the G color (60%), so that the above-mentioned condition (1) is satisfied.

In Figure 25 which illustrates spectral sensitivity characteristics of a color filter array (light receiving element), a peak of the transmittance of the transparent filter W (a peak of the sensitivity of a white pixel) is in the range of wavelength 480 nm or more and 570 nm or less. Further, the transmittance of the transparent filter W is higher than the transmittances of R and B filters in the range of wavelength 500 nm or more and 560 nm or less. Hence, the transparent filter W also satisfies the above-mentioned conditions (2) and (3). Note that the G filter also satisfies the above-mentioned conditions (1) to (3) similar to the transparent filter W.

As described above, the transparent filter W satisfies the above-mentioned conditions (1) to (3), and can be used for the first filter of the present invention. Note that in the color filter array, a part of the G filters corresponding to the G color which contributes the most to a brightness signal among the three primary colors RGB is replaced with the transparent filters W, and, consequently, the transparent filter W also satisfies the above-mentioned condition (4).

### <Emerald Filter (E filter)>

Although a color filter formed with chromatic filters corresponding to RGB colors has been mainly described in the above-mentioned embodiments, a part of these chromatic filters may be other chromatic filters, and may be, for example, filters E (emerald pixels) corresponding to an emerald (E) color. The emerald filters (E filters) may be arranged instead of a part of the first filters (G filters) in particular. Thus, by using a color filter array of four colors whose part of G filters are replaced with the E filters, it is possible to enhance reproducibility of high band components of brightness, reduce jagginess and enhance the sense of resolution.

In Figure 26 which illustrates spectral sensitivity characteristics of a color filter array (light receiving element), a peak of the transmittance of the emerald filter E (a peak of sensitivity of the E pixel) is in the range of wavelength 480 nm or more and 570 nm or less. Further, the transmittance of the emerald filter E is higher than the transmittances of the R B filters in the range of wavelength 500 nm or more and 560 nm or less. Hence, the emerald filter E satisfies the above-mentioned conditions (2) and (3). Further, in the color filter array, a part of the G filters corresponding to the G color which contributes the most to a brightness signal among the three primary colors of RGB are replaced with the emerald filters E, and consequently, the emerald filter E also satisfies the above-mentioned condition (4).

Note that in the spectral characteristics illustrated in Figure 26, the emerald filter E has a peak closer to a short wavelength side than a peak of the G filter, but may have a peak closer to a long wavelength side than the peak of the G filter (the color looks like little yellow-tinged) in some cases. Thus, filters which satisfy each condition of the present invention can be selected for the emerald filter E, and, for example, the emerald filter E which satisfies the condition (1) can also be selected.

### <Types of Other Colors>

Although the color filter array formed with color filters of the primary colors RGB has been described in each of the above-mentioned embodiments, the present invention is also applicable to, for example, a color filter array of complementary color filters having four colors consisting of G and the complementary colors of the primary colors RGB which are C (cyan), M (magenta) and Y (yellow). Also in this case, color filters which satisfy one of the above-mentioned conditions (1) to (4) are the first filters, and other color filters are the second filters.

### <Honeycomb Arrangement>

Although each color filter array according to each of the above-mentioned embodiments includes a basic array pattern formed by two-dimensionally arraying a color filter of each color in the horizontal direction (H) and the vertical direction (V), and is formed by repeatedly arranging the basic array patterns in the horizontal direction (H) and the vertical direction (V), the present invention is not limited to this.

For example, a basic array pattern of so-called honeycomb array configured by rotating the basic array pattern of each of the above-mentioned embodiments by 45° around the optical axis may be used, and a color filter may be configured by an array pattern in which the basic array pattern is repeatedly arranged in the diagonal directions (NE and NW).

Further, needless to say, the present invention is not limited to the above-mentioned embodiments, and various modifications can be made as long as the modifications do not deviate from the spirit of the present invention.

### {Reference Signs List}

9 ... digital camera, 12, 26, 30, 32, 36, 39, 45, 48, 52, 55, 57 ... color imaging element, 23R ... R filter, 23G ... G filter, 23B ... B filter, 24a, 27a, 40a, 46a, 49a, 53a, 58a ... A array, 24b, 27b, 40b, 46b, 49b, 53b, 53b1, 58b ... B array, 40c, 46c, 53c, 53c1, 58c ... C array, 40d, 46d, 53d, 58d ... D array, 28, 33, 41a, 41b, 50 ... sub array group, P, P1, P1a, P2, P3, P4, P5, P5a, P6, P6a, P7, P8, P9, P10 ... basic array pattern

## Claims

1. A single-plate color imaging element configured by disposing color filters on a plurality of pixels formed with photoelectric conversion elements arrayed in a horizontal direction and a vertical direction, wherein
an array of the color filters includes sub arrays formed by arraying the color filters according to an array pattern corresponding to N × N (N is an even number) pixels, sub array groups formed by arranging the sub arrays in one direction of the horizontal direction and the vertical direction are repeatedly arranged in another direction of the horizontal direction and the vertical direction, and the sub array groups which are mutually adjacent in the other direction are arranged by being shifted by M (M is less than N) pixel intervals in the one direction,
the color filters include first filters corresponding to a first color with one or more colors and second filters corresponding to a second color with two or more colors whose contribution rates for acquiring a brightness signal are lower than a contribution rate of the first color, and further a ratio of a number of pixels of the first color corresponding to the first filter is greater than a ratio of a number of pixels of each color of the second color corresponding to the second filters,
the first filters are arranged along at least a diagonal line of the sub arrays,
one or more of the second filters corresponding to each color of the second color are arranged on each filter line in the horizontal and vertical directions of the array of the color filters in a basic array pattern, the basic array pattern being repeatedly arranged in the horizontal direction and the vertical direction in the array of the color filters, and corresponding to arbitrary 2N × 2N pixels included in the array of the color filters, and
the M is set to such a value that one or more of the first filters are arranged on each filter line in horizontal, vertical, diagonal upper right and diagonal lower right directions of the array of the color filters.

2. The color imaging element according to claim 1, wherein the basic array pattern includes one or more of each of the sub arrays included in each of the mutually adjacent sub array groups.

3. The color imaging element according to claim 1 or 2, wherein
the N is an even number of 4 or more, and
the first filter is arranged along at least two diagonal lines of the sub arrays.

4. The color imaging element according to claim 3, wherein one or more of the second filters of each color of the second color are arranged on each filter line in the horizontal and vertical directions of the array of the color filters in the sub arrays.

5. The color imaging element according to claim 3 or 4, wherein the array of the color filters includes a square array corresponding to 2 × 2 pixels formed with the first filters.

6. The color imaging element according to claim 1, wherein, when the N is 2, the first filters are arranged along one diagonal line of the sub arrays.

7. The color imaging element according to any one of claims 1 to 6, wherein an even-numbered sub array group arranged in the other direction is arranged by being shifted by the M pixel intervals to the same direction from an odd-numbered sub array group arranged in the other direction.

8. The color imaging element according to any one of claims 1 to 7, wherein the N is 10 or less.

9. The color imaging element according to any one of claims 1 to 8, wherein
the first color is green (G), and
the second color is red (R) and blue (B).

10. An imaging apparatus comprising the color imaging element according to any one of claims 1 to 9.
